(19) Europäisches Patentamt / European Patent Office / Office européen des brevets

(11) **EP 2 950 372 B1**

(12) **EUROPEAN PATENT SPECIFICATION**

(45) Date of publication and mention
of the grant of the patent:
**27.02.2019 Bulletin 2019/09**

(21) Application number: **14843175.2**

(22) Date of filing: **18.03.2014**

(51) Int Cl.:
*H01M 4/485* (2010.01)  *H01M 4/525* (2010.01)
*C30B 29/32* (2006.01)  *C30B 29/30* (2006.01)
*C01G 35/00* (2006.01)  *C01G 33/00* (2006.01)
*H01M 10/0525* (2010.01)  *H01M 4/62* (2006.01)
*H01M 4/587* (2010.01)  *H01M 4/36* (2006.01)
*H01M 4/1391* (2010.01)  *H01M 4/131* (2010.01)
*H01M 4/02* (2006.01)  *H01M 2/34* (2006.01)
*H01M 10/42* (2006.01)  *H01M 10/48* (2006.01)

(86) International application number:
**PCT/JP2014/057401**

(87) International publication number:
**WO 2015/140936 (24.09.2015 Gazette 2015/38)**

(54) **ACTIVE MATERIAL FOR NON-AQUEOUS ELECTROLYTE BATTERY, NON-AQUEOUS ELECTROLYTE BATTERY, AND BATTERY PACK**

AKTIVMATERIAL FÜR EINE SEKUNDÄRBATTERIE MIT NICHTWÄSSRIGEM ELEKTROLYTEN, BATTERIE MIT NICHTWÄSSRIGEM ELEKTROLYTEN UND BATTERIEPACK

MATÉRIAU ACTIF POUR UNE BATTERIE À ÉLECTROLYTE NON AQUEUX, BATTERIE À ÉLECTROLYTE NON AQUEUX, ET BLOC DE BATTERIES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**02.12.2015 Bulletin 2015/49**

(73) Proprietor: **Kabushiki Kaisha Toshiba**
**Minato-ku**
**Tokyo 105-8001 (JP)**

(72) Inventors:
• **ISE, Kazuki**
**Tokyo 1058001 (JP)**

• **HARADA, Yasuhiro**
**Tokyo 1058001 (JP)**
• **TAKAMI, Norio**
**Tokyo 1058001 (JP)**

(74) Representative: **Hoffmann Eitle**
**Patent- und Rechtsanwälte PartmbB**
**Arabellastraße 30**
**81925 München (DE)**

(56) References cited:
**EP-A2- 2 503 625**   **JP-A- 2012 018 778**
**JP-A- 2013 062 183**   **JP-A- 2013 164 934**
**US-A1- 2013 209 863**

**Description**

Technical Field

Embodiments described herein relate generally to an active material for a nonaqueous electrolyte battery, a nonaqueous electrolyte battery, and a battery pack.

Background Art

Recently, a nonaqueous electrolyte battery such as a lithium-ion secondary battery has been developed as a battery having a high energy density. The nonaqueous electrolyte battery is expected to be used as a power source for vehicles such as hybrid vehicles or electric cars or a large-sized power source for electricity storage. Particularly, for use in vehicles, the nonaqueous electrolyte battery is desired to have other performances such as rapid charge/discharge performances and long-term reliability. For example, a nonaqueous electrolyte battery enabling rapid charge/discharge not only remarkably shortens the charging time but also makes it possible to improve performances of the motive force of a hybrid vehicle and to efficiently recover the regenerative energy of them.

In order to enable rapid charge/discharge, it is necessary that electrons and lithium ions can migrate rapidly between the positive electrode and the negative electrode. When a battery using a carbon based material in the negative electrode repeats rapid charge/discharge, dendrite precipitation of metal lithium is occurred on the electrode. Dendrite causes internal short circuits, which can lead heat generation and fires.

In light of this, a battery including a metal composite oxide as a negative electrode active material in place of a carbonaceous material has been developed. Particularly, in a battery including titanium oxide as the negative electrode active material, rapid charge/discharge can be performed stably. Such a battery also has a longer life than those using a carbonaceous material.

However, a potential of the titanium oxide based on Li standard is higher (nobler) than the potential of carbonaceous material based on Li standard. Further, the titanium oxide has a lower capacity per weight. Thus, a battery formed by using the titanium oxide has a problem such that the energy density is low.

The potential of the electrode including the titanium oxide is about 1.5 V based on Li standard and is higher (nobler) than that of the negative electrode including the carbonaceous material. The potential of titanium oxide is due to the redox reaction between $Ti^{3+}$ and $Ti^{4+}$ when Li is electrochemically absorbed and released. Therefore, it is limited electrochemically. Further, there is the fact that rapid charge/discharge of lithium ion can be stably performed at an electrode potential as high as about 1.5 V. Therefore, it is substantially difficult to drop the potential of the electrode to improve energy density.

As to the capacity of the battery per unit weight, the theoretical capacity of a lithium-titanium composite oxide such as $Li_4Ti_5O_{12}$ is about 175 mAh/g. On the other hand, the theoretical capacity of a known graphite type electrode material is 372 mAh/g. Therefore, the capacity density of the titanium oxide is significantly lower than that of the carbon type material. This is due to a reduction in substantial capacity because there are only a small number of Li-absorbing sites in the crystal structure and Li tends to be stabilized in the structure.

In view of such circumstances, a new electrode material containing Ti and Nb has been examined. Particularly, the theoretical capacity of a composite oxide represented by $TiNb_2O_7$ is as high as 387 mAh/g because a charge compensation is carried out in such a manner that Ti is reduced from a tetravalent state to a trivalent state and Nb is reduced from a pentavalent to a trivalent state during Li insertion, which attracts attention.

However, in the case of $TiNb_2O_7$, the electron conductivity of an active material having Li unabsorbed therein is low. Thus, the overvoltage in a low state-of-charge (SOC) region is increased. As a result, the input-output characteristics of a battery are decreased. The reaction of $TiNb_2O_7$ upon Li insertion is a solid solution formation reaction. Consequently, the volume expands and shrinks during absorption and release of Li and the electron conductivity is also low, which causes significant cycle deterioration due to breakage of conductive paths.

Patent Literature 1 or US 2013/209863 A1 (which is from the same the patent family) is concerned with an active material for a battery including a complex oxide containing niobium and titanium. A ratio $M_{Nb}/M_{Ti}$ of a mole of niobium $M_{Nb}$ to a mole of titanium $M_{Ti}$ in the active material satisfies either the following equation (I) or (II) : $0.5 \leq M_{Nb}/M_{Ti} < 2$ (I) ; $2 < M_{Nb}/M_{Ti} < 5$ (II). The active material may include a first phase constituted of $Nb_2TiO_7$ and a second phase constituted of titanium dioxide.

JP 2012-018778 A inter alia describes an active material for batteries. The active material includes secondary particles whose average particle diameter is 1 $\mu$m or more and 100 $\mu$m or less, and which include primary particles of monoclinic system $\beta$-type titanium composite oxide, whose average primary particle diameter is 1 nm or more and 10 $\mu$m or less. The composite oxide may contain Nb.

Citation List

Patent Literature

Patent Literature 1: Jpn. Pat. Appln. KOKAI Publication No. 2013-164934

Non Patent Literature

Non Patent Literature 1: Anna Lashtabeg et al., Ionics, 2003, 9, 220-226

Summary of Invention

Technical Problem

According to the embodiment, there is provided an active material for a nonaqueous electrolyte battery excellent in input-output characteristics and cycle characteristics, a nonaqueous electrolyte battery including the active material, and a battery pack including the battery.

Solution to Problem

According to one embodiment, there is provided an active material for a nonaqueous electrolyte battery including monoclinic niobium-titanium composite oxide particles as defined in appended claim 1. The monoclinic niobium-titanium composite oxide particles contain a rutile type niobium-titanium composite oxide. The active material is a composite of the rutile type niobium-titanium composite oxide and the monoclinic niobium-titanium composite oxide. The rutile type niobium-titanium composite oxide is contained in and/or covers at least a part of a surface of the monoclinic niobium-titanium composite oxide particles.

According to one embodiment, there is provided a nonaqueous electrolyte battery including a positive electrode, a negative electrode, and a nonaqueous electrolyte. The negative electrode contains the active material for the nonaqueous electrolyte battery according to the embodiment.

According to one embodiment, there is provided a battery pack including the nonaqueous electrolyte battery according to the embodiment.

Brief Description of Drawings

FIG. 1 is a pattern diagram showing a crystal structure of an active material for a nonaqueous electrolyte battery of an embodiment.

FIG. 2 is a pattern diagram of the crystal structure of FIG. 1 as seen from the crystal axis direction different from that of FIG. 1.

FIG. 3 is a cross-sectional view showing a flat-shaped nonaqueous electrolyte battery according to an embodiment.

FIG. 4 is an enlarged sectional view of a portion A of FIG. 3.

FIG. 5 is a partially cut perspective view schematically showing another flat-shaped nonaqueous electrolyte battery according to the embodiment.

FIG. 6 is an enlarged sectional view of a portion B of FIG. 5.

FIG. 7 is an exploded perspective view of a battery pack according to an embodiment.

FIG. 8 is a block diagram showing the electric circuit of the battery pack of FIG. 7.

FIG. 9 is a view showing an XRD spectrum obtained from an active material of Example 1.

FIG. 10 is a view showing an EDX spectrum obtained from a phase of $TiNb_2O_7$ of Example 1.

FIG. 11 is a view showing an EDX spectrum obtained from a rutile type $TiO_2$ of Example 1.

FIG. 12 is a view showing a micro-Raman spectrum obtained by micro-Raman spectroscopy of the active material of Example 1 at a measurement wavelength of 514.5 nm.

FIG. 13 is a view showing a micro-Raman spectrum obtained by micro-Raman spectroscopy of the active material of Example 8 at a measurement wavelength of 514.5 nm.

Description of Embodiments

Hereinafter, embodiments will be described with reference to the drawings. The same reference numerals denote common portions throughout the embodiments and overlapped description is not repeated. Each drawing is a pattern diagram for explaining the embodiments and for promoting the understanding thereof. Though there are parts different from an actual battery in shape, dimension and ratio, these structural designs may be appropriately changed taking the following explanations and known technologies into consideration.

(First Embodiment)

According to a first embodiment, there is provided an active material for a nonaqueous electrolyte battery containing monoclinic niobium-titanium composite oxide particles as defined in appended claim 1. The monoclinic niobium-titanium composite oxide particles contain a rutile type niobium-titanium composite oxide. The present inventors have found out that when the rutile type oxide absorbs Li in an early stage of charge-discharge and the electron conductivity of the monoclinic niobium-titanium composite oxide particles is improved, the input-output performance in a low state-of-charge (SOC) region is improved and the charge-discharge cycle performance is also improved by a reduction in breakage of conductive paths.

The rutile type oxide contains a rutile type niobium-titanium composite oxide. It can further contain the rutile type titanium dioxide. The rutile type titanium dioxide absorbs Li at an electrode potential of 3 V (v.s. Li$^+$/Li) or lower. However, the rutile type titanium dioxide has a narrow gap structure and this results in a low diffusion rate of Li in solid. Thus, even if the electrode potential is returned, a part of Li remains without being completely detached from the rutile type titanium dioxide and Ti remains in a trivalent state. Therefore, a state with the electron conductivity improved can be maintained by the absorption of Li. The rutile type titanium dioxide in monoclinic niobium-titanium composite oxide particles ensures the electron conductivity after the first charge-discharge cycle. Accordingly, it is possible to improve rate characteristics and charge-discharge cycle characteristics.

According to the present invention, the rutile type titanium dioxide contains an Nb element. That is, the rutile type niobium-titanium composite oxide can further improve the electron conductivity. This is considered due to a structural defect. When the rutile type titanium dioxide with a tetravalent Ti includes a pentavalent Nb, the electroneutrality is impaired. As a result, a structural defect is formed, and the structural defect causes an influence. On the other hand, an anatase type titanium dioxide (i.e., non-rutile type) shows a high reversibility of absorption and release of Li as compared to that of the rutile type structure. Thus, the electron conductivity of the anatase type upon non-discharging is lower than that of the rutile type.

The rutile type niobium-titanium composite oxide desirably has a composition ratio represented by Formula (1) below. Thus, an active material with high electron conductivity can be obtained. The composition ratio is more preferably $0.02 \leq (N/T) \leq 2.0$.

$$0 < (N/T) \leq 2 \quad (1)$$

In this regard, N represents the mole number of Nb, and T represents the mole number of Ti.

In the rutile type niobium-titanium composite oxide, the pentavalent Nb may be replaced with the tetravalent Nb. In this case, the rutile type niobium-titanium composite oxide can be represented by $Nb_{1.33}Ti_{0.67}O_4$. Although the electroneutrality is maintained because the Nb element is tetravalent, the electron conductivity of $Nb_{1.33}Ti_{0.67}O_4$ is higher than that of $TiNb_2O_7$. Thus, the electron conductivity of the active material can be improved.

The rutile type niobium-titanium composite oxide is contained in the monoclinic niobium-titanium composite oxide particles and/or covers at least a part of a surface of the monoclinic niobium-titanium composite oxide particles. For example, in order to cover the surface of the particles, in the case where the rutile type oxide is a layered substance or a particulate substance, the electron conductivity between the particles in an electrode can be improved. In this case, the rutile type oxide may be a layered or particulate substance that covers the whole surface layer of the active material particles or a layered or particulate substance that covers some of the active material particles. In the case of covering the whole surface layer of the active material particles, it is possible to suppress the deterioration due to the surface reaction of $TiNb_2O_7$. The partial covering allows the electron conductivity to be improved without inhibiting the absorption of Li into $TiNb_2O_7$. As the rutile type oxide is contained in the monoclinic niobium-titanium composite oxide particles, the electron conductivity of the primary particles can be improved.

These processes are appropriately changed according to the synthesis method and conditions of the active material.

In the case where the rutile type titanium dioxide is a particulate substance, the primary particle diameter is preferably 1 μm or less. When the primary particle diameter is 1 μm or less, the absorption of Li can be sufficiently progressed and the electron conductivity can be sufficiently improved.

The monoclinic niobium-titanium composite oxide particles desirably have a crystal structure identical or equiv-

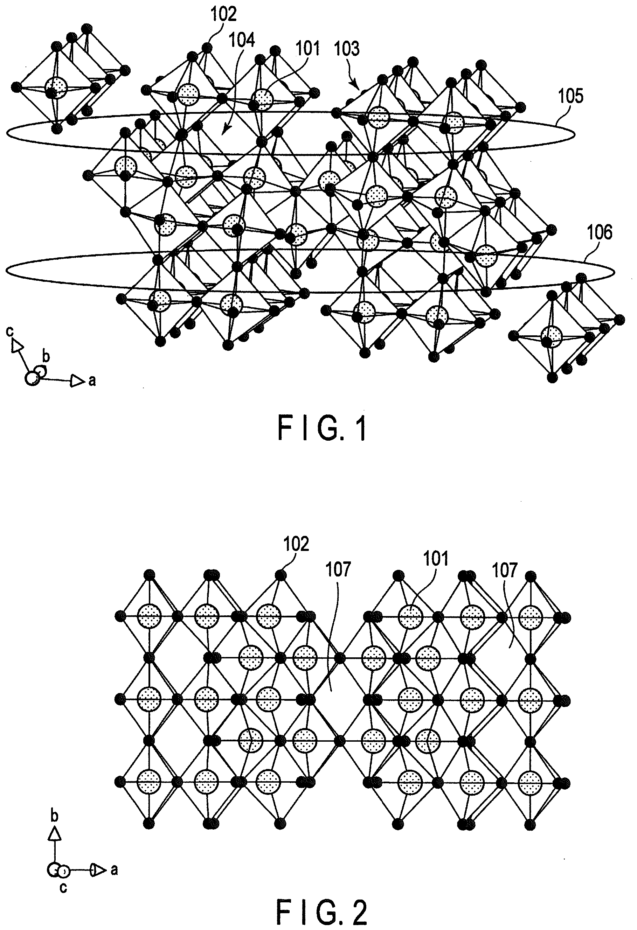

alent to that of $TiNb_2O_7$. Here, the term "crystal structure equivalent to that of $TiNb_2O_7$" means a structure satisfying the following conditions: (1) The crystal structure is contained in a group of C2/m; (2) The crystal structure is illustrated by FIGS. 1 and 2; and (3) The crystal structure has a peak derived from $TiNb_2O_7$ in wide-angle X-ray scattering measurement.

The pattern diagram of the crystal structure of $TiNb_2O_7$ shown in FIGS. 1 and 2 will be described. As shown in FIG. 1, the crystal structure of monoclinic $TiNb_2O_7$ includes skeletal structures 103 including metal ions 101 and oxide ions 102. Nb and Ti ions are randomly located in a metal ion 101 at a Nb/Ti ratio of 2 : 1. The skeletal structures 103 are arranged three-dimensionally alternately, and a void 104 is present between the skeletal structures 103. The void 104 serves as a host of lithium ion.

In FIG. 1, areas 105 and 106 are portions with two-dimensional channels in directions [100] and [010]. As shown in FIG. 2, in the crystal structure of monoclinic $TiNb_2O_7$, a void 107 is present in a direction [001].

The void 107 has a tunnel structure advantageous for the conduction of lithium ions and serves as a conduction path connecting the areas 105 and 106 in a [001] direction. Therefore, lithium ions can go back-and-forth between the areas 105 and 106 through the conduction path.

Thus, the monoclinic crystal structure has an equivalently large space into which lithium ions are inserted and has a structural stability. Further, the structure has two-dimensional channels enabling rapid diffusion of lithium ions and conduction paths connecting these channels in the direction [001]. Then, the lithium ions are inserted into and released from the insertion spaces effectively, and the insertion and release spaces for lithium ions are effectually increased. Therefore, the monoclinic crystal structure can provide a high capacity and high rate performance.

Further, when lithium ions are inserted in the void 104, the metal ion 101 constituting the skeleton is reduced to a trivalent one, thereby maintaining electroneutrality of a crystal. In a monoclinic niobium-titanium composite oxide, not only a Ti ion is reduced from tetravalent to trivalent but also an Nb ion is reduced from pentavalent to trivalent. For this, the number of reduced valences per active material weight is large. Therefore, the electroneutrality of the crystal can be maintained, even if many lithium ions are inserted. For this, the energy density of the oxide is high than that of a compound only containing a tetravalent cation, such as titanium oxide. The theoretical capacity of the monoclinic niobium-titanium composite oxide is about 387 mAh/g, and it is more than twice the value of the titanium oxide having a spinel structure.

The monoclinic niobium-titanium composite oxide has a Li absorption potential of about 1.5 V (vs. Li/Li$^+$). Therefore, since the monoclinic niobium-titanium composite oxide has a crystal structure equivalent to that of $TiNb_2O_7$, it is possible to provide a battery which can be repeatedly and rapidly charged and discharged in a stable manner.

For the above described reasons, since the monoclinic niobium-titanium composite oxide has a crystal structure identical or equivalent to that of $TiNb_2O_7$, it is possible to provide an active material for a nonaqueous electrolyte battery having excellent rapid charge/discharge performance and high energy density.

The composition of the monoclinic niobium-titanium composite oxide having a rutile type oxide contained therein (the total composition including the rutile type oxide) is desirably represented by $Li_aTi_{1+A}M_bNb_{2\pm\beta}O_{7+2A\pm\sigma}$ ($0 \leq A \leq 0.6$, $0 \leq a \leq 5$, $0 \leq b \leq 0.3$, $0 \leq \beta \leq 0.3$, $0 \leq \sigma \leq 0.3$, and M represents at least one element selected from the group consisting of Fe, V, Mo, and Ta). Here, Li represents one that is absorbed and released in the charge-discharge reaction.

The reason why the range of a is $0 \leq a \leq 5$ is that Li is contained in an amount corresponding to greater than the theoretical capacity when a exceeds 5, and battery characteristics are reduced due to insertion of an excessive amount of Li.

In the case where the content of the rutile type oxide included in the monoclinic niobium-titanium composite oxide is high, A is greater than 0. In the case where A is greater than 0.6, the amount of rutile oxide included in the monoclinic niobium-titanium composite oxide is excessive. Thus, this is not preferred.

Since a part of the Ti element can be replaced with the Nb element, $\beta$ is preferably $0 \leq \beta \leq 0.3$. In the case where $\beta$ is greater than 0.3, it exceeds the solubility limit. Thus, the crystallinity is decreased, and the capacity of the active material and rate characteristics are reduced.

The Ti element or the Nb element can be replaced with the M element. Here, M represents at least one element selected from the group consisting of Fe, V, Mo, and Ta.

In the case where b exceeds 0.3, it exceeds the substitution limit and the crystallinity of the monoclinic niobium-titanium composite oxide is reduced. Thus, the range is preferably $0 \leq b \leq 0.3$.

Fe represents a trivalent element and replaces the Ti element so as to maintain the electroneutrality of the active material including the pentavalent Nb element. Thus, an improvement in the electron conductivity of the active material can be expected. Ta and V represent a pentavalent element and replace the Nb element. Ta is a material included in the columbite (i.e., a mineral ore including Nb). Equivalent characteristics can be obtained even if Ta is replaced with the Nb element. The V element can improve the electron conductivity, and a starting material containing V is effective as a sintering aid. Thus, it is expected to make the melting point low. M represents a hexavalent element and replaces the Nb element so as to maintain the electroneutrality of the active material including the tetravalent Ti element. A starting material containing Mo is effective as a sintering aid, and thus it is expected to make the melting point low.

Regarding the 0 element, it is possible to quantify it by inert gas fusion-infrared absorptiometry. However, it is difficult to accurately quantify it in principle of the measurement device because of the influence of impurities such as moisture and an organic compound which are adhered to the surface. Therefore, when the composition is represented by $Li_aTi_{1+A}M_bNb_{2\pm\beta}O_{7+2A\pm\sigma}$, an error range of the concentration of oxygen is $\pm0.3$ ($0 \le \sigma \le 0.3$). The reason why the range of $\sigma$ is set to $0 \le \sigma \le 0.3$ is that if $\sigma$ exceeds 0.3, an abundance ratio of a subphase such as $Nb_{10}Ti_2O_{29}$ or $Nb_{24}TiO_{62}$ to a main phase of $Nb_2TiO_7$ is increased, and the amount of inserting Li is decreased.

The active material of the embodiment preferably includes a carbon-containing layer which covers the surface of the active material. In the case where a particulate or layered substance of the rutile type oxide covers at least a part of the surface of the monoclinic niobium-titanium composite oxide particles, the carbon-containing layer can cover at least one of the rutile type oxide or the monoclinic niobium-titanium composite oxide. Further, in the case where the rutile type oxide is contained in the monoclinic niobium-titanium composite oxide particles, the carbon-containing layer can cover at least a part of the surface of the particles. Examples of carbon materials included in the carbon-containing layer include carbon black and graphite.

The BET specific surface area of the active material is desirably set to a range of 1 m$^2$/g to 50 m$^2$/g. When the specific surface area is set to 1 m$^2$/g or more, the contact area between the negative electrode active material and the nonaqueous electrolyte can be sufficiently ensured, excellent discharge rate characteristics are easily obtained, and further the charging time can be reduced. On the other hand, in the case where the specific surface area is set to 50 m$^2$/g or less, it is possible to prevent the reactivity of the negative electrode with the nonaqueous electrolyte from being too high. Thus, cycle life characteristics of a nonaqueous electrolyte battery comprising the above negative electrode can be improved. Further, it is possible to improve coating properties of a slurry containing an active material which is used to produce an electrode to be described below.

Here, the term "BET specific surface area" means a specific surface area determined by the BET method. The specific surface area of the particles is generally measured using a method in which molecules whose adsorption occupied area is known are allowed to adsorb to the surface of powder particles at the temperature of liquid nitrogen to find the specific surface area of the sample from the amount of the adsorbed molecules. Among them, the most frequently used method is a BET method based on the low temperature/low humidity physical adsorption of an inert gas. This method is a method in which the Langmuir theory as a monolayer adsorption theory is extended to multilayer adsorption and is the best-known method as a calculation method of the specific surface area of a solid such as a powder or particles.

The crystal states of the monoclinic niobium-titanium composite oxide and the rutile type oxide can be observed, for example, using the powder X diffraction method (XRD). In this regard, however, in the case where the content of rutile type oxide is low, it may not be detected by XRD measurement. In this case, the state can be identified by another measurement method.

A scattering angle $2\theta$ is determined from the position of the diffraction peak obtained by the XRD measurement, and a crystal spacing d is calculated by the Bragg's law. The analysis allows the crystal structure (crystal system) to be identified. Further, known substances can be identified by referring to diffraction data of standard substances such as cards of the Joint Committee on Powder Diffraction Standards (JCPDS).

The powder X-ray diffraction measurement of the active material is performed as follows: First, a target sample is ground to an average particle diameter of 5 $\mu$m or less. Alternatively, particles having an average particle diameter of 5 $\mu$m or less are selected using a sieve from the target sample. The average particle diameter can be determined by the laser diffractometry. In order to check whether or not the grinding influences on the crystallizability of the sample, it is conformed whether or not a half-width value of the main peak is changed before and after the grinding.

A holder portion with a depth of 0.2 mm or more formed on a glass sample plate is filled with the sample ground. Then, another glass plate is pressed against the sample to smooth the surface thereof. In this case, a care must be taken to prevent the occurrence of cracks and voids due to a deficiency amount of the sample to be filled. In order to determine the peak accurately, the filling process is performed, so as to prevent the generation of parts which depress or protrude from the standard level of the holder.

Then, the glass plate filled with the sample is placed in a powder X-ray diffractometer and a diffraction pattern is obtained using Cu-K$\alpha$ rays.

An orientation of the particles may be influenced depending on the particle shape of the sample, and the position of a peak may be shifted or the intensity ratio may be changed. In such a case, the same sample is filled in a Lindemann glass capillary and the measurement is performed using a rotary sample stand, whereby the influence of the orientation can be determined. In the case where there is a difference in the intensity ratio exceeding the device tolerance on a specific surface comparing the X-ray charts obtained, a measurement result obtained by using the rotary sample stand is used.

When the powder X-ray diffraction measurement is performed on the active material contained in the electrode, it can be performed, for example, as follows: First, in order to analyze the crystal state of the active material, the active material is put into a state in which lithium ions are perfectly released from the active material. For example, when the active material is used in the negative electrode, the battery is put into a fully discharged state. In this regard, however, there is a case where lithium ions still remain even in a discharged state, and thus attention should be paid to the analysis results.

Next, the battery is disintegrated in a glove box filled with argon. Then, the electrode is taken out and washed with an appropriate solvent. For example, ethyl methyl carbonate may be used. In the case where the electrode is washed insufficiently, it may sometimes be contaminated with an impurity phase of lithium carbonate or lithium fluoride due to the influence of the lithium ions remaining in the electrode. In such a case, it is better to use an airtight container in which the measurement can be performed in an inert gas atmosphere. The washed electrode is cut into a size having almost the same area of the holder of the powder X-ray diffractometer. This sample is attached directly to the glass holder so as to have the same height as that of the standard level of the holder, followed by measurement of the sample. At this time, a peak corresponding to the metallic foil included in the electrode substrate is previously measured to obtain the peak position derived from the electrode substrate, and the peak position can be omitted from the measurement result. Further, peak positions of other components such as a conductive agent and a binder are previously measured, and the peak positions can be omitted from the measurement results in the same manner as above. When the peak of the electrode substrate is overlapped on the peak of the active material, it is desired to separate the active material from the substrate prior to the measurement. This is necessary to measure the peak intensity accurately. The electrode is immersed in a solvent such as ethyl methyl carbonate and ultrasonic wave is applied to the substrate, whereby the active material can be separated from the substrate. The electrode mixed powder (including the active material, the conductive agent, and the binder) recovered by volatilizing the solvent is filled in, for example, a Lindemann glass capillary and the powder X-ray diffraction of the active material is measured. The electrode mixed powder recovered in the same manner as above may be subjected to various chemical analyses.

Desirably, the active material of the embodiment has a peak A corresponding to the Raman band of the rutile type oxide appeared at 430 cm$^{-1}$ to 450 cm$^{-1}$ (preferably 440 $\pm$ 10 cm$^{-1}$), a peak B corresponding to the Raman band of the niobium-titanium composite oxide appeared at 640 cm$^{-1}$ to 660 cm$^{-1}$ (preferably 650 $\pm$ 10 cm$^{-1}$), and a peak C corresponding to the Raman band of the niobium-titanium composite oxide appeared at 260 cm$^{-1}$ to 280 cm$^{-1}$ (preferably 270 $\pm$ 10 cm$^{-1}$) appear in the spectrum obtained by micro-Raman spectroscopy at a measurement wavelength of 514.5 nm, and satisfies at least one of Formula (1) or Formula (2).

$$0.25 \leq I_A/I_C \leq 0.45 \quad (1)$$

$$0.7 \leq I_B/I_C \leq 1.2 \quad (2)$$

$I_A$ represents the intensity of the peak A, $I_B$ represents the intensity of the peak B, and $I_C$ represents the intensity of the peak C. First, (1) will be described. In the case where the active material contains the rutile type oxide, a peak appears at 430 cm$^{-1}$ to 450 cm$^{-1}$. Thus, the presence of the rutile type oxide can be confirmed. The content of the rutile type oxide can be determined by the intensity $I_A$ of the peak A and the intensity $I_C$ of the peak C. The intensity ratio is preferably $0.25 \leq I_A/I_C \leq 0.45$. An intensity ratio ($I_A/I_C$) of less than 0.25 indicates that the content of the rutile type oxide is low. An improvement in electron conductivity is small. This may cause a decrease in characteristics. An intensity ratio ($I_A/I_C$) of greater than 0.45 indicates that the amount of the rutile type oxide becomes excessive. Thus, this may cause a significant decrease in capacity.

Formula (2) will be described. In the case where the active material contains $Nb_{1.33}Ti_{0.67}O_4$, the active material has a rutile type structure. However, the excitation light is absorbed upon the micro-Raman measurement because the electron conductivity is high, and thus it is difficult to quantify the Raman bands. However, in the case of the monoclinic niobium-titanium composite oxide containing $Nb_{1.33}Ti_{0.67}O_4$, the crystal structure is changed by the formation of $Nb_{1.33}Ti_{0.67}O_4$. This change can be observed by micro-Raman measurement. Thus, the content of $Nb_{1.33}Ti_{0.67}O_4$ can be determined by an intensity ratio of Raman bands of the monoclinic niobium-titanium composite oxide. Specifically, it is observed that the intensity $I_B$ of the peak B is relatively decreased in accordance with the formation of $Nb_{1.33}Ti_{0.67}O_4$. An intensity $I_B$ of the peak B and an intensity $I_C$ of the peak C preferably satisfy $0.7 \leq I_B/I_C \leq 1.2$. The fact that an intensity ratio ($I_B/I_C$) is less than 0.7 indicates that the content of $Nb_{1.33}Ti_{0.67}O_4$ is high. In this case, diffusion of Li is inhibited and the resistance is increased, and thus battery characteristics may be impaired. In the case where the intensity ratio ($I_B/I_C$) is greater than 1.2, the content of $Nb_{1.33}Ti_{0.67}O_4$ is low, and thus it may be unexpected that an improvement in battery characteristics due to an improvement in electron conductivity of a target.

The micro-Raman spectroscopy is carried out, for example, by the following method.

Apparatus: T-6400, manufactured by HORIBA Jobin Yvon S.A.S.
Measurement mode: macro-Raman
Beam diameter: 100 $\mu$m

Light source: Ar + laser/514.5 nm
Laser power: 10 mW
Diffraction grating: Spectrograph 1800 gr/mm
Dispersion: Single 21A/mm
Slit: 100 $\mu$m
Detector: CCD (manufactured by Jobin Yvon, 1024 x 256)

Since a plurality of Raman bands of $TiNb_2O_7$ is overlapped, quantitative values may be different depending on the fitting method. Thus, the values are not calculated by the fitting method. The spectrum maximum value is defined as the peak intensity. However, during the measurement of the niobium-titanium composite oxide, a background appears due to influences such as a difference in measurement system, a method of placing a sample, and fluorescent light shown from the sample body. This background affects the sample peak intensity and thus the intensity may not be exactly calculated. In this case, for example, a particulate material having the same primary particle diameter which is formed of a single phase of $TiNb_2O_7$ is prepared, and the relative comparison is performed in order to observe the presence or absence of the rutile type structure and a change in a peak of the Raman band. In the case where the influence of fluorescent light cannot erased and the evaluation is still difficult after the above process, the intensity (excluding the background) is exactly evaluated by fitting the background caused by the fluorescent light by a cubic spline function and performing peak fitting by a Pseudo-Voigt function.

In the case where the rutile type titanium dioxide and the rutile type niobium-titanium composite oxide are mounted on a battery, and the battery is charged and discharged, Li is absorbed and released. However, the rutile type oxide has a narrow gap structure and this results in a low diffusion rate of Li in solid. Thus, even if the electrode potential of the inserted Li is returned, a part of Li remains without being completely released and Ti remains in a trivalent state. Thus, in the case of the electrode after charge-discharge, it may be difficult to identify the structure by the above method. Therefore, the identification of the structure of the active material included in the battery is performed by, for example, the following TEM observation and FFT analysis.

The active material or the electrode is coated with an epoxy resin. Thereafter, the fixed sample is mechanically polished and then the resultant sample is thinned by ion milling. As an ion milling device, for example, DualMill600 (manufactured by GATAN) is used. For example, the TEM analyzer and observation conditions are shown as follows:

Measurement device: H-9000UHR III, manufactured by Hitachi, Ltd.
Accelerating voltage: 300 kV

The magnification of an image is set to 400000. Particles showing lattice images are found from the obtained image. Reciprocal lattice images are obtained by Fourier-transformation of the lattice images of the particles.

The FFT analysis is performed, for example, in the following manner. A negative film photographed at a magnification of x 400000 is digitized (4000 dpi) using a negative scanner. The resultant image is expanded to 5 times (800 dpi) using the image software in the PC. Then, a checkerboard portion produced on the image software screen is cut into a size of about 500 px$\varphi$. After that, the cut portion is Fourier transformed using image analysis software to obtain an FFT pattern. As the image analysis software, for example, CryStMapp (manufactured by NEC Corporation) may be used.

The monoclinic niobium-titanium composite oxide and the rutile type oxide can be distinguished from the thus obtained FFT pattern. In this regard, however, all particles are not always distinguished clearly because the FFT pattern varies depending on the crystal orientation of particles and the degree of ion milling. Therefore, an image is photographed at a magnification of 50000 (field of vision), and all particles in the image are subjected to the same analysis to determine the presence or absence of the rutile type oxide. Further, only a part of information on all the particles is obtained from the image obtained by TEM observation. Consequently, the operation is performed, preferably 5 times or more to determine whether the reproducibility is sufficient.

The rutile type oxide which the composition ratio (N/T) satisfies Formula (1) can be identified by EDX analysis. The identification based on EDX analysis is carried out, for example, by the following method.

Measurement device: JEM2300T, manufactured by JEOL Ltd.
System: Analysis Stasion
Image acquisition: Digital Micrograph
Measurement voltage: 200 kV
Beam diameter: 0.7 to 1 nm
Measurement time: 15 sec to 30 sec

The obtained image is subjected to two-dimensional mapping based on the spectrum obtained from EDX analysis. The division between the monoclinic oxide and the rutile type oxide may be determined by the shade of the Nb element and the Ti element. In order to determine the presence or absence of a mixed phase of the above oxides accurately, the process is carried out, for example, by the following method. Arbitrary particles are calculated from the obtained image. The particles are divided into 5 nm x 5 nm square regions. The divided points are subjected to EDX measurement to obtain a representative spectrum. In the case where the rutile type oxide having a composition ratio satisfying Formula (1) is included, the peak intensity of Ti in the spectrum to be obtained is relatively higher than that of the spectrum obtained in $TiNb_2O_7$. Therefore, the presence or absence of the rutile type oxide can be determined by this method.

The FFT analysis and EDX analysis allow for the determination of the presence or absence of the rutile type oxide in an electrode containing Li included in the battery.

The active material for the nonaqueous electrolyte battery of the first embodiment is produced, for example, by a method of producing an active material for a nonaqueous electrolyte battery of a second embodiment, however the method is not particularly limited thereto.

According to the active material for the nonaqueous electrolyte battery of the first embodiment, since monoclinic niobium-titanium composite oxide particles containing a rutile type oxide are included, it is possible attain a nonaqueous electrolyte battery which exerts a high input-output performance even in a low SOC region and is excellent in charge-discharge cycle performance.

(Second Embodiment)

According to a second embodiment, there is provided a method of producing an active material for a nonaqueous electrolyte battery. A first method of producing an active material for a nonaqueous electrolyte battery includes rapidly heating a precursor which contains an amorphous compound hydroxide containing Nb and Ti to a temperature of 1000°C or more with a rate of temperature increase of 30°C/min so as to be heat-treated. On the other hand, a second method of producing an active material for a nonaqueous electrolyte battery includes heat-treating a monoclinic niobium-titanium composite oxide having a crystal structure equivalent to that of $TiNb_2O_7$ in a reduction atmosphere to form a rutile type $Nb_{1.33}Ti_{0.67}O_4$.

First, the first method of producing an active material for a nonaqueous electrolyte battery will be described. In this method, a composite of monoclinic niobium-titanium composite oxide and rutile type oxide can be obtained.

In the case where which a large amount of Nb element is contained in the rutile type titanium dioxide, it can be produced by, for example, the following liquid phase synthesis. In the liquid phase synthesis, the reaction progresses in a state where the Nb element and the Ti element are mixed at an atomic level. Thus, a large amount of Nb element can be contained in the rutile type titanium dioxide. Further, $TiNb_2O_7$ can be formed in a shorter calcination time. Accordingly, it is possible to decrease the particle diameter of the rutile type titanium dioxide in the monoclinic niobium-titanium composite oxide particles.

First, an acid solution (A) containing the Ti compound dissolved therein is mixed with an acid solution (B) containing the Nb compound dissolved therein. Starting materials of the acid solutions are particularly limited. A solution to be used is prepared by dissolving a hydroxide, a sulfide, an oxide, salts, an alkoxide, or an organic compound which contain Ti or Nb in a suitable solvent such as pure water, ethanol or acid. During the mixing process, the mixing ratio of the acid solution (A) to the acid solution (B) is adjusted so that the mole ratio of Nb/Ti (N/T) is $1 \leq (N/T) \leq 2$. More preferably, the mole ratio is $1.3 \leq (N/T) \leq 1.9$. The mole ratio herein is a mole ratio upon the preparation process, and it may be different from the composition ratio of Nb to Ti in the active material after production.

After that, the thus prepared mixed solution containing the Ti compound and the Nb compound is mixed with an alkali solution as a pH adjuster so as to precipitate a coprecipitation product. The alkali solution is preferred as the pH adjuster. The pH of the alkali solution is 8 or more, more preferably 12 or more. In the case of a solution with a high pH, a coprecipitation product can be precipitated from a small amount of the solution. Thus, this is preferred. For example, ammonia water is used as the pH adjuster. In the mixing method, the pH adjuster may be dropped into the mixed solution containing the Ti compound and the Nb compound, reversely, the mixed solution containing the Ti compound and the Nb compound may be dropped into the pH adjuster. The aggregation degree and particle shape of a precipitation product can be controlled according to the method of dropping the solution, the speed, and the timing. A method of gradually adding a small amount of pH adjuster to a mixed solution is more preferred from the viewpoint of suppressing excessive aggregation. The pH adjuster is added in order to adjust the pH of a mixed liquid containing Ti and Nb to alkaline. The pH may be adjusted while monitoring precipitation conditions of a coprecipitation product. As a guide, the pH is in a range of 1 to 10, preferably in a range of 6 to 9. Thus, a coprecipitation product containing Ti and Nb can be precipitated.

Further, heat-treatment is performed in a closed autoclave container before and after the process of adjusting the pH, whereby the content of the Nb element in the rutile type titanium dioxide can be further increased. Preferably, the heating temperature in the autoclave container is 200°C or more and the calcination time is 5 hours or more. Under such conditions, an anatase type titanium dioxide excessively doped with Nb is formed, and a precursor in which Nb is previously doped in titanium dioxide is obtained. When the precursor is heat-treated, a part of the precursor with the Nb element contained therein is phase-changed to a rutile type titanium dioxide. On the other hand, $TiNb_2O_7$ is also formed, whereby monoclinic system niobium-titanium composite oxide particles containing rutile type titanium dioxide doped with Nb can be obtained.

Subsequently, the coprecipitation product is washed. Pure water is preferably used as a cleaning solution. As a guide, the washing process is sufficiently performed until the pH of the waste liquid after washing is in a range of 6 to 8, more preferably in a near-neutral range. After sufficiently washing, filtration and drying processes are performed to obtain a precursor powder.

The precursor thus obtained is a coprecipitation product containing Nb and Ti, more preferably an amorphous compound hydroxide. An amorphous precursor powder containing a uniform mixture of Ti and Nb is formed in the above manner, whereby the reactivity during calcination is improved, the Nb-Ti composite oxide can be calcined at a low temperature in a short time as compared to the conventional solid reaction method, and the temperature and time in the subsequent calcination process can be controlled.

The precursor powder after filtration and drying may aggregate. Further, the grain size of primary particles may vary due to the influence of the type of starting material. In that case, it is preferable to grind the primary particles by a mechanical grinding method such as ball milling or bead milling.

Subsequently, the obtained precursor powder is calcined. The calcination is performed at a temperature within a range of 700°C to 1200°C. The calcination time is set to a range of 1 hour to 12 hours. More preferably, the calcination temperature is from 950°C to 1100°C, and the calcination time is from 1 hour to 5 hours. The calcination is performed under the conditions, whereby a phase of monoclinic niobium-titanium composite oxide can be formed.

In the case where the calcination temperature is 800°C or more, the grain growth or necking between particles proceeds. Thus, from the viewpoint of improving the crystallinity while suppressing the grain growth or necking between particles, an annealing process at a temperature of 600°C to 800°C for 1 hour to 24 hours can be added before and after the calcination.

In the calcination of the precursor, the heat treatment is performed by rapidly heating preferably to a temperature of 1000°C or more (with a rate of temperature increase of 30°C/min) so as to be heat-treated. The formation of $TiNb_2O_7$ is caused at a temperature of 900°C or more, meanwhile, the formation of anatase type titanium dioxide is initiated at 400°C and the formation of rutile type titanium dioxide is initiated at 800°C. Thus, when the rate of temperature increase is slow, titanium dioxide is formed faster. The calcined rutile type titanium dioxide is separated from $TiNb_2O_7$, which may cause independent precipitation.

The calcination atmosphere may be any of an air atmosphere, an inert gas atmosphere such as nitrogen, argon or helium, and a vacuum atmosphere. In order to obtain an oxide, an oxidizing atmosphere is preferred. Specifically, the air atmosphere is preferred. Further, the calcination process may be performed in an air atmosphere whose oxygen concentration is intentionally increased.

The particles in the calcined powder may be necked with each other or the particles may grow excessively. Therefore, the powder can be ground by a mechanical grinding method such as ball milling or bead milling to form fine particles. Thus, this is preferred. In this regard, however, when the mechanical grinding method is performed, the crystallinity of the active material may be impaired. This case can be improved by performing the annealing process at a temperature within a range of 600°C to 800°C for 1 hour to 24 hours again after the above process. Thus, this is preferred.

Further, the calcined powder may be mixed with carbon. The method of mixing with carbon is not particularly limited. Examples of the carbon source include saccharides, polyolefins, nitriles, alcohols, and other organic compounds containing a benzene ring. It is possible to allow the material to be supported by carbon black or graphite using a mechanical method such as planetary ball milling. The calcined powder is mixed with the carbon source, followed by calcination in a reduction atmosphere. The calcination temperature is preferably 900°C or less. In the case where the calcination temperature is more than 900°C, the reduction reaction of the Nb element is progressed, which may cause deposition of different phases. The reduction atmosphere is preferably an atmosphere such as nitrogen, carbon dioxide or argon.

Further, in the case where the grain size after calcination is 1 $\mu$m or less, when pelletization is performed by a method such as spray dry, the dispersibility of a slurry in an electrode forming process is improved and the liquid coating properties is stabilized. Thus, this is preferred.

Hereinafter, the method of producing a second active material for a nonaqueous electrolyte battery will be described. In this method, a composite of monoclinic niobium-titanium composite oxide and $Nb_{1.33}Ti_{0.67}O_4$ can be obtained.

In the case where a composite of $Nb_{1.33}Ti_{0.67}O_4$ is produced, for example, monoclinic niobium-titanium composite oxide particles having a crystal structure equivalent to that of $TiNb_2O_7$ is heat-treated in a reduction atmosphere. When the calcination is performed in the reduction atmosphere, the monoclinic niobium-titanium composite oxide is partially reduced (for example, the Nb element in $TiNb_2O_7$ in a surface layer is reduced to a tetravalent state). As a result, $Nb_{1.33}Ti_{0.67}O_4$ is formed.

The monoclinic niobium-titanium composite oxide particles to be used can be produced by, for example, a solid reaction method. As starting materials, an Nb-containing solid powder and a Ti-containing solid powder are used. Usable examples thereof include niobium oxide, niobium hydroxide, titanium oxide, and titanium hydroxide.

First, the Nb-containing solid powder and the Ti-containing solid powder are sufficiently mixed at a predetermined mole ratio. The particle diameter of the solid powder is preferably 1 $\mu$m or less. This results in an improvement in the reactivity.

A temporary calcination process can be performed before a main calcination process. The temporary calcination temperature is desirably in a range of 600°C to 1100°C. The temporary calcination is performed, whereby a small amount of an impure component (e.g., water or an organic compound) which is absorbed to raw powder can be removed. Further, a two-step calcination process is employed, whereby the crystallinity of the calcined active material can be improved.

The main calcination temperature is desirably in a range of 1000°C to 1350°C, and the calcination time is preferably 12 hours or more.

Because of the grain growth of the powder after the main calcination, the particle diameter may be as large as several 10 $\mu$m or more. In the case of making the particle diameter smaller, the grinding process is performed by a method such as wet beads milling. However, in this case, the crystallinity may be significantly reduced. Therefore, it is preferable to perform an annealing process at 600°C to 800°C for a calcination time of about 1 hour to 5 hours.

The monoclinic niobium-titanium composite oxide particles can be produced by the solid reaction method as described above.

Subsequently, the obtained powder was calcined in a reduction atmosphere. As for the reduction atmosphere, an inert gas such as argon, nitrogen or carbon dioxide is mixed with hydrogen gas for use. As for the mixing ratio of hydrogen, the volume ratio is preferably from 3% to 5%. Thus, the reduction reaction can be accelerated. Preferably, the calcination temperature in a reduction atmosphere is from 900°C to 1100°C and the calcination time is 2 hours or more and less than 24 hours. In the case where the calcination time is in less than 2 hours, $Nb_{1.33}Ti_{0.67}O_4$ is not sufficiently formed. In the case where the calcination time is 24 hours or more, $Nb_{1.33}Ti_{0.67}O_4$ is excessively formed. Accordingly, the capacity of the battery and the diffusion of Li into the monoclinic niobium-titanium composite oxide are decreased.

Further, the calcined powder may be mixed with carbon. The method of mixing with carbon is not particularly limited. Examples of the carbon source include saccharides, polyolefins, nitriles, alcohols, and other organic compounds containing a benzene ring. It is possible to allow the material to support carbon black or graphite using a mechanical method such as planetary ball milling. The calcined powder is mixed with the carbon source, followed by calcination in a reduction atmosphere. The calcination temperature is preferably 900°C or less. In the case where the calcination temperature is more than 900°C, the reduction reaction of the Nb element is progressed, which may cause deposition of different phases. The reduction atmosphere is preferably an atmosphere such as nitrogen, carbon dioxide or argon.

According to the method of producing the active material for the nonaqueous electrolyte battery of the second embodiment, since an active material containing monoclinic niobium-titanium composite oxide particles containing a rutile type oxide can be provided, it is possible attain a nonaqueous electrolyte battery which exerts a high input-output performance even in a low SOC region and is excellent in charge-discharge cycle performance.

(Third Embodiment)

A nonaqueous electrolyte battery according to a third embodiment includes a positive electrode, a negative electrode containing the active material according to the first embodiment, and a nonaqueous electrolyte. This nonaqueous electrolyte battery may further include a separator and a container.

Hereinafter, the positive electrode, the negative electrode, the nonaqueous electrolyte, the separator, and the container will be described in detail.

1) Positive Electrode

The positive electrode includes a current collector and a positive electrode layer formed on one surfaces or both surfaces of the current collector and containing an active material and a binder (positive electrode active material containing layer).

As the active material, an oxide, a sulfide, a polymer or the like may be used. Examples of the active material include manganese dioxide capable of absorbing Li ($MnO_2$), iron oxide capable of absorbing Li, copper oxide capable of absorbing Li, nickel oxide capable of absorbing Li, lithium manganese composite oxide (for example, $Li_xMn_2O_4$ or $Li_xMnO_2$), lithium nickel composite oxide (e.g., $Li_xNiO_2$), lithium cobalt composite oxide (e.g., $Li_xCoO_2$), lithium nickel cobalt composite oxide (e.g., $LiNi_{1-y}Co_yO_2$), lithium manganese cobalt composite oxide (e.g., $Li_xMn_yCo_{1-y}O_2$), spinel type lithium manganese nickel composite oxide (e.g., $Li_xMn_{2-y}Ni_yO_4$), lithium phosphorus-containing compound having an olivine structure (e.g., $Li_xFePO_4$, $Li_xFe_{1-y}Mn_yPO_4$, $Li_xCoPO_4$), iron sulfate [$Fe_2(SO_4)_3$], vanadium oxide (e.g., $V_2O_5$), and lithium nickel cobalt manganese composite oxide. Here, x and y are $0 < x \leq 1$ and $0 < y \leq 1$. As the active material, these compounds may be used alone or in combination of a plurality of compounds.

As the polymer, a conductive polymer material such as polyaniline or polypyrrole, or a disulfide-based polymer material may be used. Sulfur (S) and carbon fluoride are also usable for the active material.

Examples of a preferred active material include lithium manganese composite oxide ($Li_xMn_2O_4$), lithium nickel composite oxide ($Li_xNiO_2$), lithium cobalt composite oxide ($Li_xCoO_2$), lithium nickel cobalt composite oxide ($LiNi_{1-y}Co_yO_2$), spinel type lithium manganese nickel composite oxide ($Li_xMn_{2-y}Ni_yO_4$), lithium manganese cobalt composite oxide ($Li_xMn_yCo_{1-y}O_2$), lithium iron phosphorus-containing compound ($Li_xFePO_4$), and lithium nickel cobalt manganese composite oxide, each of which has a high positive electrode voltage. Here, x and y are $0 < x \leq 1$ and $0 < y \leq 1$.

Particularly, when a nonaqueous electrolyte containing room temperature molten salt is used, it is preferable to use lithium iron phosphorus-containing compound, $Li_xVPO_4F$, a lithium manganese composite oxide, a lithium nickel composite oxide, and a lithium nickel cobalt composite oxide from the viewpoint of cycle life. This is because the reactivity of the positive electrode active material with room temperature molten salt is decreased.

The specific surface area of the active material is preferably from 0.1 $m^2$/g to 10 $m^2$/g. In the case of the positive electrode active material having a specific surface area of 0.1 $m^2$/g or more, the absorption and release site of lithium ions can be sufficiently ensured. In the case of the positive electrode active material having a specific surface area of 10 $m^2$/g or less, the handling in the industrial production is made easy and good charge and discharge cycle performance can be ensured.

The binder is used to bind the active material with the current collector. Examples of the binder include polytetrafluoroethylene (PTFE), polyvinylidene fluoride (PVdF), and fluorine-based rubber.

The conductive agent is added, if necessary, to improve the current collection performance and suppress the contact resistance with the collector. Examples of the conductive agent include carbonaceous materials such as acetylene black, carbon black, and graphite.

In the positive electrode active material containing layer, the active material and binder are preferably formulated in a ratio of 80% by weight or more and 98% by weight or less and in a ratio of 2% by weight or more and 20% by weight or less, respectively.

When the amount of the binder is 2% by weight or more, sufficient electrode strength is obtained. Further, when the amount of the binder is 20% by weight or less, the amount of the insulating material of the electrode can be reduced, leading to reduced internal resistance.

When the conductive agent is added, the active material, binder, and conductive agent are added in amounts of 77% by weight or more and 95% by weight or less, 2% by weight or more and 20% by weight or less and 3% by weight or more and 15% by weight or less respectively. When the amount of the conductive agent is 3% by weight or more, the above effect can be exerted. Further, when the amount of the conductive agent is 15% by weight or less, the decomposition of the nonaqueous electrolyte on the surface of the positive electrode conductive agent during storage at high temperatures can be reduced.

The current collector is preferably an aluminum foil or an aluminum alloy foil containing at least one element selected from the group consisting of Mg, Ti, Zn, Ni, Cr, Mn, Fe, Cu, and Si.

The thickness of the aluminum foil or aluminum alloy foil is preferably from 5 $\mu$m to 20 $\mu$m, more preferably 15 $\mu$m or less. The purity of the aluminum foil is preferably 99% by weight or more. The content of transition metals such as iron, copper, nickel, or chromium contained in the aluminum or aluminum alloy foil is set to, preferably 1% by weight or less.

The positive electrode is produced by suspending the active material, the binder, and the conductive agent to be added, if necessary in an appropriate solvent to prepare a slurry, coating the positive electrode current collector with the slurry, drying the resultant product to form a positive electrode layer, and pressing the layer. Alternatively, the positive electrode may be produced by forming the active material, the binder, and the conductive agent to be added, if necessary into pellets to form a positive electrode layer, and forming the positive electrode layer on the current collector.

2) Negative Electrode

The negative electrode includes a current collector and a negative electrode layer formed on one surface or both surfaces of the current collector and containing an active material and a binder (negative electrode active material containing layer).

The active material is desirably the active material for the nonaqueous electrolyte battery described in the first embodiment. As the active material, the active material according to the first embodiment may be used alone or mixed with other active materials for use. Usable examples of other active materials include anatase type titanium dioxide $TiO_2$, β-type titanium dioxide, $Li_2Ti_3O_7$ (i.e., ramsdellite-type lithium titanate), $Li_4Ti_5O_{12}$ (i.e., spinel-type lithium titanate), niobium oxide, and niobium containing composite oxide. Since these oxidized compounds have a specific gravity close to that of the compound contained in the active material according to the first embodiment and are easily mixed and dispersed, they are appropriately used.

The conductive agent improves the conductive performance of the active material and controls the contact resistance with the current collector. Examples of the conductive agent include carbonaceous materials such as acetylene black, carbon black, and graphite.

The binder is added to fill gaps of the dispersed negative electrode active material and bind the active material to the conductive agent. Examples of the binder include polytetrafluoroethylene (PTFE), polyvinylidene fluoride (PVdF), fluorine-based rubber, and styrene butadiene rubber.

Preferably, blending rates of the active material, the conductive agent, and the binder in the negative electrode layer are from 68 to 96% by weight, from 2 to 30% by weight, and from 2 to 30% by weight, respectively. In the case where the amount of the conductive agent is 2% by weight or more, the current collection performance of the negative electrode layer can be improved. In the case where the amount of the binder is 2% by weight or more, the binding property of the negative electrode layer and the current collector is sufficient and excellent cycle characteristics can be expected. On the other hand, the amounts of the conductive agent and the binder are preferably set to 30% by weight or less from the viewpoint of high capacity performance.

A material which is electrochemically stable at the Li absorption and release potential of the negative electrode active material is used for the current collector. The current collector is preferably made of copper, nickel, stainless steel or aluminium, or an aluminium alloy containing at least one element selected from the group consisting of Mg, Ti, Zn, Mn, Fe, Cu, and Si. The thickness of the current collector is preferably from 5 $\mu$m to 20 $\mu$m. The current collector having such a thickness can balance the strength and reduction in weight of the negative electrode.

The negative electrode is produced by suspending the active material, the conductive agent, and the binder in a solvent to prepare a slurry, coating the current collector with the slurry, drying the resultant product to form a negative electrode layer, and pressing the layer. Alternatively, the negative electrode may be produced by forming the active material, conductive agent, and binder into pellets to form a negative electrode layer, and forming the negative electrode layer on the current collector.

3) Nonaqueous Electrolyte

The nonaqueous electrolyte may be, for example, a liquid nonaqueous electrolyte prepared by dissolving an electrolyte in an organic solvent or a gel-like nonaqueous electrolyte which is a composite of a liquid electrolyte and a polymer material.

The liquid nonaqueous electrolyte is preferably prepared by dissolving an electrolyte in an organic solvent at a concentration of 0.5 mol/L to 2.5 mol/L.

Examples of the electrolyte include lithium salts of lithium perchlorate ($LiClO_4$), lithium hexafluorophosphate ($LiPF_6$), lithium tetrafluoroborate ($LiBF_4$), lithium hexafluoro arsenate ($LiAsF_6$), lithium trifluoromethanesulfonate ($LiCF_3SO_3$), bistrifluoromethylsulfonylimidelithium [$LiN(CF_3SO_2)_2$], and mixtures thereof. Preferably, the electrolyte is hardly oxidized even at a high potential, and $LiPF_6$ is most preferred.

Examples of the organic solvent include cyclic carbonates such as propylene carbonate (PC), ethylene carbonate (EC), and vinylene carbonate; linear carbonates such as diethyl carbonate (DEC), dimethyl carbonate (DMC), and methylethyl carbonate (MEC); cyclic ethers such as tetrahydrofuran (THF), 2-methyltetrahydrofuran (2MeTHF), and dioxolane (DOX); linear ethers such as dimethoxyethane (DME) and diethoxyethane (DEE); $\gamma$-butyrolactone (GBL); acetonitrile (AN); and sulfolane (SL).

These organic solvents may be used alone or in the form of a mixed solvent.

Examples of the polymer material include polyvinylidene fluoride (PVdF), polyacrylonitrile (PAN), and polyethylene oxide (PEO).

Alternatively, a room temperature molten salt containing lithium ions (ionic melt), polymer solid electrolyte, inorganic solid electrolyte or the like may be used as the nonaqueous electrolyte.

The room temperature molten salt (ionic melt) means compounds which can exist in a liquid state at room temperature (15 to 25°C) among organic salts constituted of combinations of organic cations and anions. Examples of the room temperature molten salt include those which solely exist in a liquid state, those which are put into a liquid state when mixed with an electrolyte, and those which are put into a liquid state when dissolved in an organic solvent.

The melting point of the room temperature molten salt to be usually used for the nonaqueous electrolyte battery is 25°C or less. Further, the organic cation has generally a quaternary ammonium skeleton.

The polymer solid electrolyte is prepared by dissolving an electrolyte in a polymer material and solidifying the mixture.

The inorganic solid electrolyte is a solid material having lithium ion-conductivity.

4) Separator

The separator may be formed of a porous film containing a material such as polyethylene, polypropylene, cellulose or polyvinylidene fluoride (PVdF), or a nonwoven fabric of a synthetic resin. Particularly, a porous film formed of polyethylene or polypropylene melts at a constant temperature and can block electric current, and thus it is preferred from the viewpoint of improvement in safety.

5) Container

As the container, a container formed of a laminate film having a thickness of 0.5 mm or less or a container formed of metal having a thickness of 1 mm or less may be used. The thickness of the laminate film is more preferably 0.2 mm or less. The thickness of the metal container is preferably 0.5 mm or less, more preferably 0.2 mm or less.

Examples of a shape of the container include a flat type (thin type), a rectangular type, a cylindrical type, a coin type, and a button type. Depending on the battery size, examples of the container include a container for a small battery which is mounted to a portable electronic device or a container for a large battery which is mounted to a two- or four-wheeled vehicle.

As the laminate film, a multilayer film in which a metal layer is formed between resin layers is used. The metal layer is preferably an aluminum foil or an aluminum alloy foil in order to reduce the weight. As the resin layer, a polymer material such as polypropylene (PP), polyethylene (PE), nylon or polyethylene terephthalate (PET) may be used. The laminate film can be molded into the shape of the container by sealing by thermal fusion bonding.

The metal container is made from aluminium or an aluminium alloy. The aluminum alloy is preferably an alloy containing at least one element selected from magnesium, zinc, and silicon. In the case where a transition metal such as iron, copper, nickel, and chromium is contained in the alloy, the amount of the transition metal is preferably 1% by weight or less. Thus, the long-term reliability in the hot environment and heat releasing property can be dramatically improved.

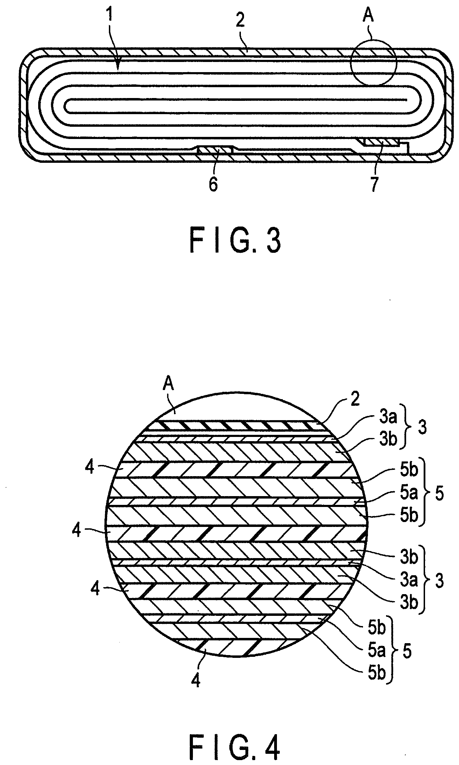

Subsequently, the nonaqueous electrolyte battery according to the third embodiment will be more specifically described with reference to the drawings. FIG. 3 is a cross-sectional view of a flat-shaped nonaqueous electrolyte battery. FIG. 4 is an enlarged sectional view of a portion A of FIG. 3. Each drawing is a pattern diagram for explaining the embodiments and for promoting the understanding thereof. Though there are points different from an actual battery in shape, dimension and ratio, these structural designs may be appropriately changed taking the following explanations and known technologies into consideration.

A flat-shaped wound electrode group 1 is housed in a sac-like container 2 formed of a laminate film in which a metal layer is formed between two resin layers. The flat-shaped wound electrode group 1 is formed by spirally winding a laminate obtained by stacking a negative electrode 3, a separator 4, a positive electrode 5, and a separator 4 in this order from the outermost member and press-molding.

The negative electrode 3 is configured to include a negative electrode current collector 3a and a negative electrode layer 3b. As shown in FIG. 4, the negative electrode 3 as the outermost layer has a configuration in which the negative electrode layer 3b is formed on only one inner surface of the negative electrode current collector 3a. The rest of the negative electrodes 3 have a structure that the negative electrode layer 3b is formed on both surfaces of the negative electrode current collector 3a.

The positive electrode 5 has a structure that the positive electrode layer 5b is formed on both surfaces of the positive electrode current collector 5a.

In a vicinity of a peripheral edge of the wound electrode group 1, a negative electrode terminal 6 is connected to the negative electrode current collector 3a of the negative electrode 3 as the outermost layer, and a positive electrode terminal 7 is connected to the positive electrode current collector 5a of the inner positive electrode 5. The negative electrode terminal 6 and the positive electrode terminal 7 are extended from an opening of the sac-like container 2 to the outside. For example, the liquid nonaqueous electrolyte is injected through the opening of the sac-like container 2. The wound electrode group 1 and the liquid nonaqueous electrolyte can be completely sealed by heat-sealing the opening of the sac-like container 2 with the negative electrode terminal 6 and the positive electrode terminal 7 projected from the container 2.

The negative electrode terminal 6 is formed from a material which is electrically stable in Li absorption-release potential of the negative electrode active material and has conductivity. Specifically, it is formed of copper, nickel, stainless steel or aluminum, or an aluminum alloy containing at least one element selected from the group consisting of Mg, Ti, Zn, Mn, Fe, Cu, and Si. It is preferable that the negative electrode terminal 6 is formed of a material similar to that of the negative electrode current collector in order to reduce the contact resistance with the negative electrode current collector 3a.

The positive electrode terminal 7 is formed of a material which has electric stability and conductivity, with a potential to a Li standard, in a range of 3 V to 5 V, preferably in a range of 3.0 V to 4.25 V. Specifically, it is formed of aluminum or an aluminum alloy containing at least one element selected from the group consisting of Mg, Ti, Zn, Ni, Cr, Mn, Fe, Cu, and Si. As for a positive electrode terminal, in order to reduce contact resistance with positive electrode current collector 5a, it is preferable to be formed from the same material as positive electrode current collector 5a.

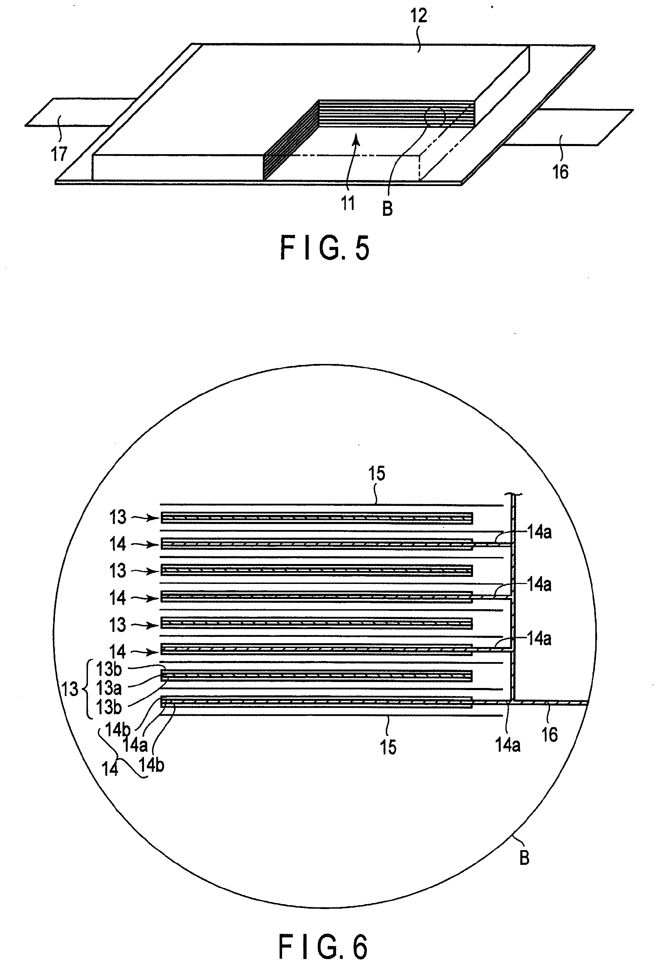

The nonaqueous electrolyte secondary battery according to the third embodiment may have not only the configurations shown in FIGS. 3 and 4, but also the configurations shown in FIGS. 5 and 6. FIG. 5 is a partially cut perspective view schematically showing another flat-shaped nonaqueous electrolyte battery according to the third embodiment. FIG. 6 is an enlarged sectional view of a B portion of FIG. 5.

The lamination-type electrode group 11 is housed in a container 12 which is formed of a laminate film in which a metal layer is provided between two resin films.

As shown in FIG. 6, the lamination-type electrode group 11 has a structure in which a positive electrode 13 and a negative electrode 14 are alternately stacked while a separator 15 is provided between the both electrodes. A plurality of the positive electrodes 13 are present and they comprise the current collector 13a and a positive electrode active material containing layer 13b formed at both surfaces of the current collector 13a. A plurality of the negative electrodes 14 are present and they comprise a negative electrode current collector 14a and a negative electrode active material containing layer 14b formed at both surfaces of the negative electrode current collector 14a. In each of the negative electrode current collectors 14a of the negative electrodes 14, a side is protruded from the negative electrode 14. The protruded negative electrode current collector 14a is electrically connected to a strip-shaped negative electrode terminal 16. The distal end of the negative electrode terminal 16 is externally drawn from the container 11. In the positive electrode current collector 13a of the positive electrode 13, not illustrated, one side located at the opposite side of the protruded side of the negative electrode current collector 14a is protruded from the positive electrode 13. The positive electrode current collector 13a protruded from the positive electrode 13 is electrically connected to a strip-shaped positive electrode terminal 17. The distal end of the strip-shaped positive electrode terminal 17 is located at the opposite side of the negative electrode terminal 16 and externally drawn from the container 11.

According to the nonaqueous electrolyte battery of the third embodiment, since the battery includes the negative electrode containing the active material for the nonaqueous electrolyte battery of the first embodiment, it is possible attain a nonaqueous electrolyte battery which exerts a high input-output performance even in a low SOC region and is excellent in charge-discharge cycle performance.

(Fourth Embodiment)

Subsequently, a battery pack according to a fourth embodiment will be described with reference to the drawing. The battery pack has one or a plurality of nonaqueous electrolyte batteries (unit cells) according to the third embodiment. When a plurality of the unit cells is included, each of the unit cells is electrically connected in series and/or in parallel.

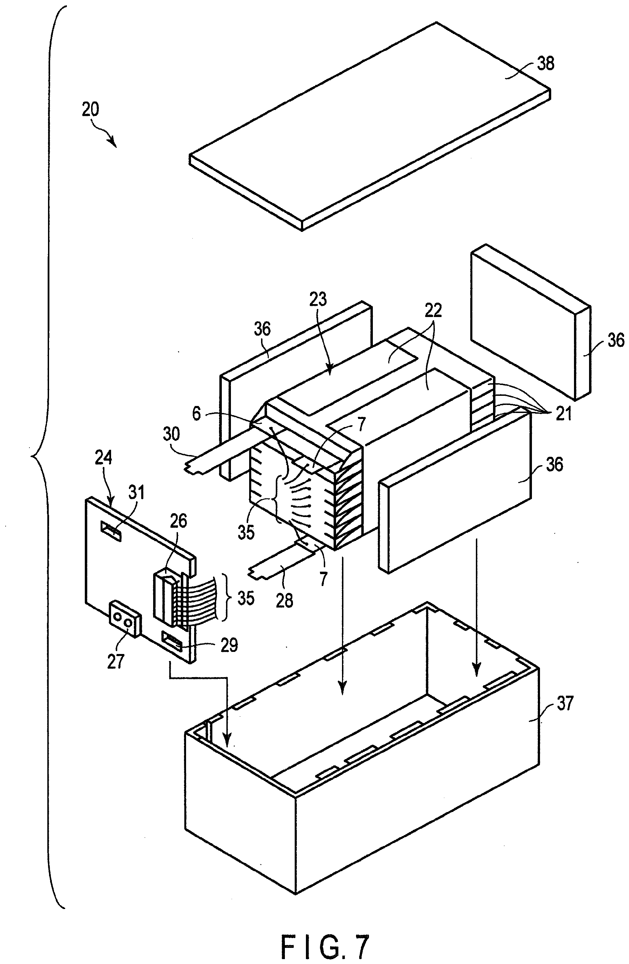

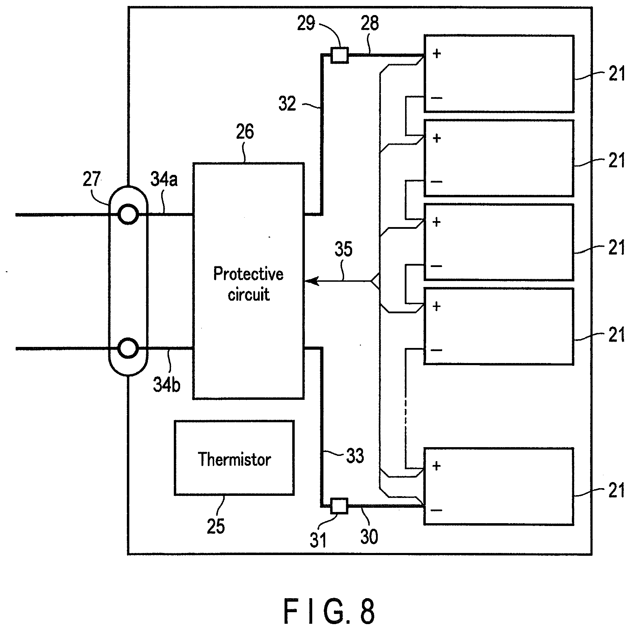

FIGS. 7 and 8 shows an example of a battery pack that includes a plurality of flat-shaped batteries shown in FIG. 3. FIG. 7 is an exploded perspective view of a battery pack. FIG. 8 is a block diagram showing the electric circuit of the battery pack of FIG. 7.

An battery module 23 is configured by stacking the unit cells 21 so that a negative electrode terminal 6 extended outside and a positive electrode terminal 7 are arranged in the same direction and fastening them with an adhesive tape 22. The unit cells 21 are electrically connected in series with one another as shown in FIG. 8.

A printed wiring board 24 is arranged opposed to the side plane of the unit cells 21 where the negative electrode terminal 6 and the positive electrode terminal 7 are extended. A thermistor 25, a protective circuit 26, and an energizing terminal 27 to an external device are mounted on the printed wiring board 24 as shown in FIG. 8. An electric insulating plate (not shown) is attached to the surface of the protective circuit board 24 facing the battery module 23 to avoid unnecessary connection of the wiring of the battery module 23.

A positive electrode lead 28 is connected to the positive electrode terminal 7 located at the bottom layer of the battery module 23 and the distal end is inserted into a positive electrode connector 29 of the printed wiring board 24 so as to be electrically connected. An negative electrode lead 30 is connected to the negative electrode terminal 6 located at the top layer of the battery module 23 and the distal end is inserted into an negative electrode connector 31 of the printed wiring board 24 so as to be electrically connected. The connectors 29 and 31 are connected to the protective circuit 26 through wirings 32 and 33 formed in the printed wiring board 24.

Thermistor 25 is used to detect the temperature of the unit cells 21. The detection signal is sent to the protective circuit 26. The protective circuit 26 can shut down a plus wiring 34a and a minus wiring 34b between the protective circuit 26 and the energizing terminals 27 to an external instrument under a predetermined condition. For example, the predetermined condition indicates when the detection temperature of the thermistor 25 becomes a predetermined temperature or more. Or, the predetermined condition indicates when the over-charge, over-discharge, and over-current of the unit cells 21 are detected. The over-charge detection may be performed on each of the unit cells 21 or the battery module. When each of the unit cells 21 is detected, the cell voltage may be detected, or positive electrode or negative electrode potential may be detected. In the case of the latter, a lithium electrode to be used as a reference electrode is inserted into each of the unit cells 21. In the case of FIGS. 7 and 8, wirings 35 for voltage detection are connected to the unit cells 21 and detection signals are sent to the protective circuit 26 through the wirings 35.

Protective sheets 36 comprised of rubber or resin are arranged on three side planes of the battery module 23 except the side plane in which the positive electrode terminal 7 and the negative electrode terminal 6 are protruded.

The battery module 23 is housed in a housing case 37 together with each of the protective sheets 36 and the printed wiring board 24. That is, the protective sheets 36 are arranged on both internal planes in a long side direction and on one of the internal plane in a short side direction of the housing case 37. The printed wiring board 24 is arranged on the other internal plane at the opposite side in a short side direction. The battery module 23 is located in a space surrounded by the protective sheets 36 and the printed wiring board 24. A lid 38 is attached to the upper plane of the housing case 37.

In order to fix the battery module 23, a heat-shrinkable tape may be used in place of the adhesive tape 22. In this case, the battery module is bound by placing the protective sheets on the both surfaces of the battery module, revolving the heat-shrinkable tape, and thermally shrinking the heat-shrinkable tape.

In FIGS. 7 and 8, the form in which the unit cells 21 are connected in series is shown. However, in order to increase the battery capacity, the cells may be connected in parallel. Alternatively, the cells may be formed by combining series connection and parallel connection. The assembled battery pack can be connected in series or in parallel.

The embodiment of the battery pack is appropriately changed according to the use. The battery pack according to the embodiment is used suitably for the application which requires the excellent cycle characteristics at a high current. It is used specifically as a power source for digital cameras, for vehicles such as two- or four-wheel hybrid electric vehicles, for two- or four-wheel electric vehicles, and for assisted bicycles. Particularly, it is suitably used as a battery for automobile use.

According to the battery pack of the fourth embodiment, since the battery pack includes a nonaqueous electrolyte battery that includes a negative electrode containing the active material for the nonaqueous electrolyte battery of the first embodiment, it is possible attain a battery pack which exerts a high input-output performance even in a low SOC region and is excellent in charge-discharge cycle performance.

Examples

Hereinafter, examples will be described. However, the present invention is not limited to the following examples unless departing from the spirit of the present invention.

(Example 1)

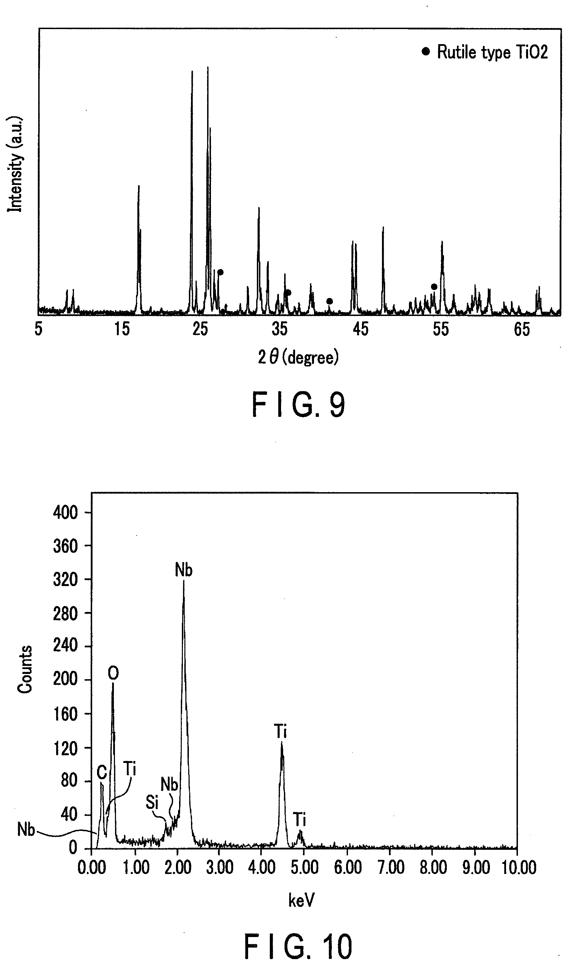

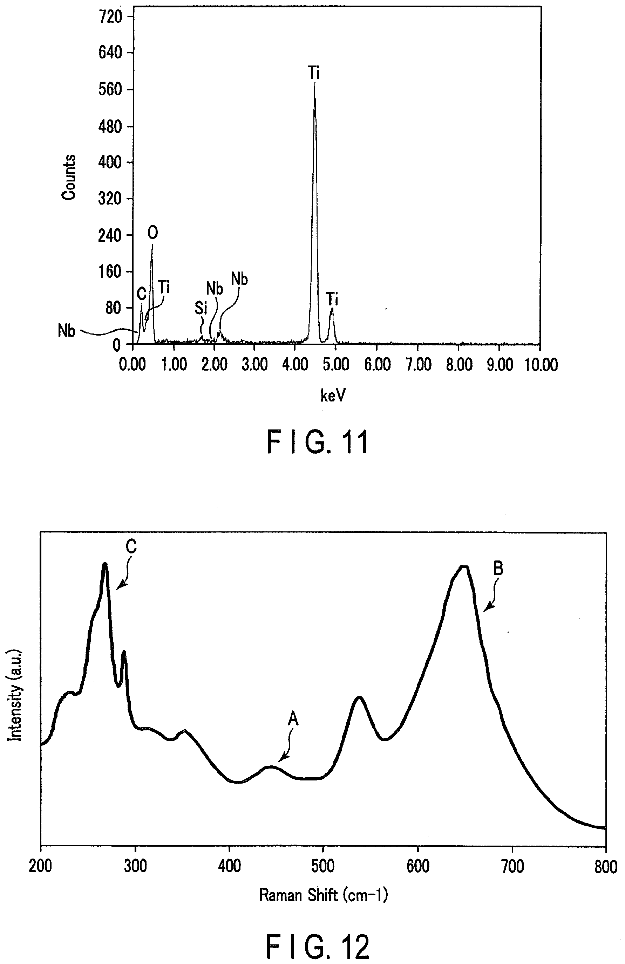

A dilute sulfuric acid solution of titanyl sulfate and an ethanol solution of niobium chloride were used as starting materials. Both the solutions were mixed to obtain a transparent mixed solution with no deposition of a foreign substance such as a hydroxide. Ammonia water was dropped into the mixed solution while stirring the solution, which resulted in a white precipitate. The obtained precipitate was washed with pure water and filtrated. Then, the resultant product was dried with a heater at 80°C and ground in a mortar to loosen the aggregation, and a precursor was obtained. After that, the precursor was calcined in the air at 1100°C (with a rate of temperature increase of 30°C/min) for 1 hour. Thereafter, the resultant product was ground again in the mortar. The composition of the active material was quantified by ICP analysis, and it was determined that the mole ratio (N/T) was 1.67 and the composition formula was $Li_0Ti_{1.20}Nb_{2.0}O_{7.40}$ ($Ti_{1.20}Nb_{2.0}O_{7.40}$). Peaks derived from the phase of $TiNb_2O_7$ and the phase of rutile type $TiO_2$ were detected by XRD measurement. The XRD measurement results are shown in FIG. 9. In FIG. 9, the peaks derived from the rutile type $TiO_2$ were indicated by black circles. Peaks other than the black circles are the peaks derived from the phase of $TiNb_2O_7$. Further, the presence of the phase of $TiNb_2O_7$ mixed with the phase of rutile type $TiO_2$ containing Nb was confirmed by EDX analysis. The EDX spectrum obtained from the phase of $TiNb_2O_7$ is shown in FIG. 10, and the EDX spectrum obtained from the phase of rutile type $TiO_2$ is shown in FIG. 11.

The atomic percentage was calculated from the EDX spectrum corresponding to the obtained rutile type $TiO_2$ and the result confirmed that about 1.5 atm% of Nb element was contained in the rutile type $TiO_2$. Namely, the obtained active material was a composite of rutile type niobium-titanium composite oxide and monoclinic niobium-titanium composite oxide and the monoclinic niobium-titanium composite oxide had a crystal structure equivalent to that of $TiNb_2O_7$. The rutile type niobium-titanium composite oxide was represented by $Ti_{0.985}Nb_{0.015}O_2$.

The obtained active material was subjected to micro-Raman spectroscopy at a measurement wavelength of 514.5 nm. The results are shown in FIG. 12. A peak A corresponding to the Raman band of rutile type oxide appeared at 440 cm$^{-1}$, a peak B corresponding to the Raman band of niobium-titanium composite oxide appeared at 652 cm$^{-1}$, and a peak C corresponding to the Raman band of niobium-titanium composite oxide appeared at 269 cm$^{-1}$. The peak intensity ratios calculated were $I_A/I_C = 0.35$ and $I_B/I_C = 1.00$, respectively.

100% by mass of the obtained active material powder, 10% by mass of acetylene black as a conductive agent, 10% by mass of polyvinylidene fluoride (PVdF) as a binder were added to N-methyl pyrrolidone (NMP), and mixed to prepare a slurry. This slurry was applied to one surface of a current collector formed of 12-$\mu$m-thick aluminum foil and dried, followed by pressing to produce an electrode having a coating weight of 25 g/m$^2$.

Ethylene carbonate (EC) and diethyl carbonate (DEC) were mixed at a volume ratio of 1 : 2 to obtain a mixed solvent. 1 mol/L of $[LiN(CF_3SO_2)_2]$ (LiTFSI supporting electrolyte) was dissolved in the mixed solvent to prepare a nonaqueous electrolyte. A three-electrode-type beaker cell was produced in an argon atmosphere using the obtained electrode as a working electrode, Li metals as a counter electrode and a reference electrode, and an electrolyte solution, and the charge and discharge characteristics were evaluated.

(Example 2)

An active material was synthesized in the same manner as Example 1 except that the calcination rate was 100°C/min, and the charge-discharge was performed. The composition of the active material was quantified by ICP analysis, and the mole ratio (N/T) was determined to be 1.67. Peaks derived from the phase of $TiNb_2O_7$ and the phase of rutile type $TiO_2$ were detected by XRD measurement. Further, the presence of the phase of $TiNb_2O_7$ mixed with the phase of rutile type $TiO_2$ containing Nb was confirmed by EDX analysis mapping. The rate of temperature increase is as high as 100°C/min, whereby growth of the phase of rutile type $TiO_2$ is suppressed. Thus, the grain diameter of the phase of rutile type $TiO_2$ is smaller than that of Example 1, and the phase of rutile type $TiO_2$ is supported by the surface of the phase (particles) of $TiNb_2O_7$. The atomic percentage was calculated from the EDX spectrum corresponding to the phase of rutile type $TiO_2$ and the result confirmed that about 1.5 atm% of Nb element was contained in the phase of rutile type $TiO_2$. Namely, the active material of Example 2 was a composite of rutile type niobium-titanium composite oxide and monoclinic niobium-titanium composite oxide and the monoclinic niobium-titanium composite oxide had a crystal structure equivalent to that of $TiNb_2O_7$. The rutile type niobium-titanium composite oxide was represented by $Ti_{0.985}Nb_{0.015}O_2$.

The obtained active material was subjected to micro-Raman spectroscopy at a measurement wavelength of 514.5 nm. A peak A corresponding to the Raman band of rutile type oxide appeared at 441 $cm^{-1}$, a peak B corresponding to the Raman band of niobium-titanium composite oxide appeared at 650 $cm^{-1}$, and a peak C corresponding to the Raman band of niobium-titanium composite oxide appeared at 270 $cm^{-1}$. The peak intensity ratios calculated were $I_A/I_C$ = 0.33 and $I_B/I_C$ = 1.02, respectively.

(Example 3)

An active material was synthesized in the same manner as Example 1 except that an ethanol solution of vanadium chloride was added as a starting material and the solution ratio of Nb/Ti elements was adjusted so as to replace the V element with the Nb element. The composition of the active material was quantified by ICP analysis, and the mole ratio (N/T) was 1.52. The content of V element was 0.05 mol.

The obtained active material was subjected to micro-Raman spectroscopy at a measurement wavelength of 514.5 nm. A peak A corresponding to the Raman band of rutile type oxide appeared at 443 $cm^{-1}$, a peak B corresponding to the Raman band of niobium-titanium composite oxide appeared at 652 $cm^{-1}$, and a peak C corresponding to the Raman band of niobium-titanium composite oxide appeared at 269 $cm^{-1}$. The peak intensity ratios calculated were $I_A/I_C$ = 0.36 and $I_B/I_C$ = 1.11, respectively.

(Example 4)

An active material was synthesized in the same manner as Example 1 except that an ethanol solution of iron nitrate was further added as a starting material and the solution ratio of the Nb element to the Ti element was adjusted so that the tetravalent Ti element was replaced with the trivalent Fe element and the pentavalent Nb element to maintain the electroneutrality. The composition of the active material was quantified by ICP analysis, and the mole ratio (N/T) was determined to be 1.52. The content of Fe element was 0.05 mol.

The obtained active material was subjected to micro-Raman spectroscopy at a measurement wavelength of 514.5 nm. A peak A corresponding to the Raman band of rutile type oxide appeared at 442 $cm^{-1}$, a peak B corresponding to the Raman band of niobium-titanium composite oxide appeared at 651 $cm^{-1}$, and a peak C corresponding to the Raman band of niobium-titanium composite oxide appeared at 268 $cm^{-1}$. The peak intensity ratios calculated were $I_A/I_C$ = 0.42 and $I_B/I_C$ = 1.09, respectively.

(Example 5)

An active material was synthesized in the same manner as Example 1 except that an ethanol solution of molybdenum chloride was further added as a starting material and the solution ratio (Nb/Ti) of the Nb element to the Ti element was adjusted so that the pentavalent Nb element was replaced with the tetravalent Ti element and the hexavalent Mo element to maintain the electroneutrality. The composition of the active material was quantified by ICP analysis, and the mole ratio (N/T) was determined to be 1.52. The content of Mo element was 0.05 mol.

The obtained active material was subjected to micro-Raman spectroscopy at a measurement wavelength of 514.5 nm. A peak A corresponding to the Raman band of rutile type oxide appeared at 440 $cm^{-1}$, a peak B corresponding to the Raman band of niobium-titanium composite oxide appeared at 649 $cm^{-1}$, and a peak C corresponding to the Raman band of niobium-titanium composite oxide appeared at 271 cm$^{-1}$. The peak intensity ratios calculated were $I_A/I_C$ = 0.35 and $I_B/I_C$ = 1.18, respectively.

(Example 6)

An active material was synthesized in the same manner as Example 1 except that an ethanol solution of tantalum chloride was added as a starting material and the solution ratio (Nb/Ti) of the Nb element to the Ti element was adjusted so as to replace the Ta element with the Nb element. The composition of the active material was quantified by ICP analysis, and the mole ratio (N/T) was determined to be 1.52. The content of Ta element was 0.05 mol.

The obtained active material was subjected to micro-Raman spectroscopy at a measurement wavelength of 514.5 nm. A peak A corresponding to the Raman band of rutile type oxide appeared at 439 cm$^{-1}$, a peak B corresponding to the Raman band of niobium-titanium composite oxide appeared at 652 cm$^{-1}$, and a peak C corresponding to the Raman band of niobium-titanium composite oxide appeared at 268 cm$^{-1}$. The peak intensity ratios calculated were $I_A/I_C$ = 0.37 and $I_B/I_C$ = 1.06, respectively.

(Example 7)

A dilute sulfuric acid solution of titanyl sulfate and an ethanol solution of niobium chloride were used as starting materials. Both the solutions were mixed to obtain a transparent mixed solution with no deposition of a foreign substance such as a hydroxide. While stirring the mixed solution, ammonia water was dropped into the mixed solution so as to adjust the pH to 7. This solution was transferred to an autoclave container, followed by a hydrothermal treatment at 240°C for 5 hours. After the hydrothermal treatment, the obtained precipitate was washed with pure water and filtrated. Then, the resultant product was dried with a heater at 80°C and ground in a mortar to loosen the aggregation, and a precursor was obtained. The obtained precursor was measured by XRD measurement and the result confirmed that the peak corresponding to the anatase phase of $TiO_2$ was detected.

The obtained precursor was calcined in the air at 1100°C (with a rate of temperature increase of 100°C/min) for 1 hour. Thereafter, the resultant product was ground again in the mortar.

Peaks derived from the phase of $TiNb_2O_7$ and the phase of rutile type $TiO_2$ were detected by XRD measurement. Further, the presence of the phase of $TiNb_2O_7$ mixed with the phase of rutile type $TiO_2$ containing Nb was confirmed by EDX analysis mapping. The atomic percentage was calculated from the EDX spectrum corresponding to the phase of rutile type $TiO_2$ and the result confirmed that about 5.0 atm% of Nb element was contained in the phase of rutile type $TiO_2$. Namely, the obtained active material was a composite of rutile type niobium titanium composite oxide and monoclinic niobium titanium composite oxide and the monoclinic niobium titanium composite oxide had a crystal structure equivalent to that of $TiNb_2O_7$. The rutile type niobium-titanium composite oxide was represented by $Ti_{0.95}Nb_{0.05}O_2$.

The obtained active material was subjected to micro-Raman spectroscopy at a measurement wavelength of 514.5 nm. A peak A corresponding to the Raman band of rutile type oxide appeared at 441 cm$^{-1}$, a peak B corresponding to the Raman band of niobium-titanium composite oxide appeared at 653 cm$^{-1}$, and a peak C corresponding to the Raman band of niobium-titanium composite oxide appeared at 273 cm$^{-1}$. The peak intensity ratios calculated were $I_A/I_C$ = 0.29 and $I_B/I_C$ = 1.02, respectively.

100% by mass of the obtained active material powder, 10% by mass of acetylene black as a conductive agent, 10% by mass of polyvinylidene fluoride (PVdF) as a binder were added to N-methyl pyrrolidone (NMP), and mixed to prepare a slurry. This slurry was applied to one surface of a current collector formed of 12-$\mu$m-thick aluminum foil and dried, followed by pressing to produce an electrode having a coating weight of 25 g/m$^2$.

Ethylene carbonate (EC) and diethyl carbonate (DEC) were mixed at a volume ratio of 1 : 2 to obtain a mixed solvent. 1 mol/L of LiTFSI supporting electrolyte was dissolved in the mixed solvent to prepare a nonaqueous electrolyte. A three-electrode-type beaker cell was produced in an argon atmosphere using the obtained electrode as a working electrode, Li metals as a counter electrode and a reference electrode, and an electrolyte solution, and the charge and discharge characteristics were evaluated.

(Example 8)

First, $TiNb_2O_7$ was synthesized by the solid-phase method. As starting materials, niobium oxide having a primary particle diameter of 1 $\mu$m or less and titanium oxide were used. Both the materials were mixed to form pellets. Then, the pellets were temporarily calcined at 1000°C for 12 hours. After that, the resultant product was ground and formed into pellets again, followed by main calcination at 1100°C for 12 hours. Thereafter, the resultant product was ground with a wet beads mill, followed by calcination for annealing at 700°C for 1 hour to obtain a powder having a particle diameter of 1 $\mu$m or less. All the calcination processes were performed in the air.

The obtained powder was measured by XRD measurement and the result confirmed that $TiNb_2O_7$ was a single

phase and no different phase was observed. Further, the mole ratio (N/T) of Nb to Ti was determined as 2 by ICP analysis.

The obtained powder was subjected to a heat treatment in a reduction atmosphere (calcination in an $Ar/H_2$ gas atmosphere including 3% of hydrogen at 1000°C for 2 hours). The obtained active material was measured by XRD measurement, and the peak corresponding to the rutile phase was detected.

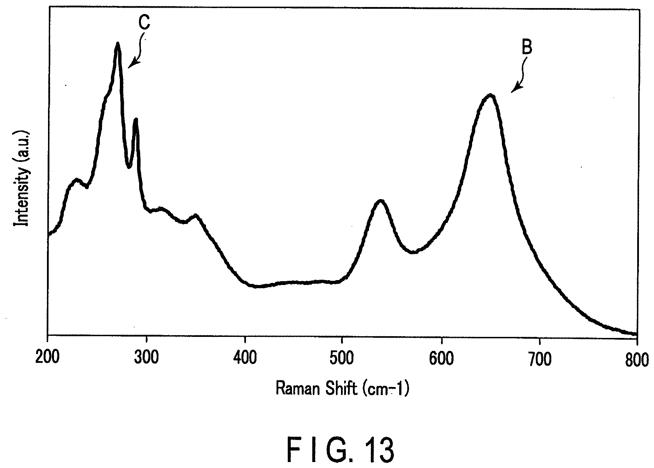

The obtained active material was subjected to micro-Raman spectroscopy at a measurement wavelength of 514.5 nm. The results are shown in FIG. 13. A peak A corresponding to the Raman band of rutile type oxide appeared at 438 cm$^{-1}$, a peak B corresponding to the Raman band of niobium-titanium composite oxide appeared at 651 cm$^{-1}$, and a peak C corresponding to the Raman band of niobium-titanium composite oxide appeared at 270 cm$^{-1}$. The peak intensity ratios calculated were $I_A/I_C = 0.26$ and $I_B/I_C = 0.82$, respectively.

The ICP analysis shows that the mole ratio (N/T) was 2.0 and the rutile phase appeared regardless of the same intensity ratio as that of $TiNb_2O_7$. Accordingly, it can be said that $Nb_{1.33}Ti_{0.67}O_4$ is formed on the surface layer of the monoclinic niobium-titanium composite oxide particles.

100% by mass of the obtained active material powder, 10% by mass of acetylene black as a conductive agent, 10% by mass of polyvinylidene fluoride (PVdF) as a binder were added to N-methyl pyrrolidone (NMP), and mixed to prepare a slurry. This slurry was applied to one surface of a current collector formed of 12-$\mu$m-thick aluminum foil and dried, followed by pressing to produce an electrode having a coating weight of 25 g/m$^2$.

Ethylene carbonate (EC) and diethyl carbonate (DEC) were mixed at a volume ratio of 1 : 2 to obtain a mixed solvent. 1 mol/L of LiTFSI supporting electrolyte was dissolved in the mixed solvent to prepare a nonaqueous electrolyte. A three-electrode-type beaker cell was produced in an argon atmosphere using the obtained electrode as a working electrode, Li metals as a counter electrode and a reference electrode, and an electrolyte solution, and the charge and discharge characteristics were evaluated.

(Comparative Example 1)

An active material and an electrode were produced in the same manner as Example 1 except that the composition ratio of the Nb element to the Ti element was changed, and the charge-discharge evaluation was performed. The mole ratio (Nb/Ti) was determined to be 2.0 by ICP analysis. The fact that the peak derived from only the phase of $TiNb_2O_7$ appeared and no rutile type $TiO_2$ was formed was confirmed by XRD measurement.

The obtained active material was subjected to micro-Raman spectroscopy at a measurement wavelength of 514.5 nm. A peak A corresponding to the Raman band of rutile type oxide appeared at 441 cm$^{-1}$, a peak B corresponding to the Raman band of niobium-titanium composite oxide appeared at 648 cm$^{-1}$, and a peak C corresponding to the Raman band of niobium-titanium composite oxide appeared at 2671 cm$^{-1}$. The peak intensity ratios calculated were $I_A/I_C = 0.25$ and $I_B/I_C = 1.12$, respectively.

(Comparative Example 2)

An active material and an electrode were produced in the same manner as Example 8 except that the calcination process in a reduction atmosphere was not performed, and the charge-discharge evaluation was performed. The fact that the peak derived from only the phase of $TiNb_2O_7$ appeared and no rutile type $TiO_2$ was formed was confirmed by XRD measurement.

The obtained active material was subjected to micro-Raman spectroscopy at a measurement wavelength of 514.5 nm. A peak A corresponding to the Raman band of rutile type oxide appeared at 439 cm$^{-1}$, a peak B corresponding to the Raman band of niobium-titanium composite oxide appeared at 647 cm$^{-1}$, and a peak C corresponding to the Raman band of niobium-titanium composite oxide appeared at 273 cm$^{-1}$. The peak intensity ratios calculated were $I_A/I_C = 0.26$ and $I_B/I_C = 1.07$, respectively.

(Comparative Example 3)

An active material was synthesized in the same manner as Example 8 except that the conditions of calcination in a reduction atmosphere was changed based on the description in Anna Lashtabeg et al., Ionics, 2003, 9, 220-226 (2. Experimental Procedure on page 221) and the calcination process was performed in an $Ar/H_2$ gas atmosphere containing 5% of hydrogen at 1000°C for 48 hours. The obtained active material was measured by XRD measurement, and the result confirmed that only the peak corresponding to the rutile phase appeared, and $TiNb_2O_7$ was completely reduced to form $Nb_{1.33}Ti_{0.67}O_4$.

Regarding the examples and the comparative examples, a first charge-discharge cycle was performed in such a manner that a constant current-constant voltage charge was carried out at a potential range of 1.0 V to 3.0 V and a current value of 0.2 C for 10 hours, and then a constant-current discharge was carried out at 0.2 C. Then, the constant current-constant voltage charge was carried out at a current value of 1C for 3 hours, and then a constant-current discharge was carried out at 20 C. After that, a process of performing a constant current-constant voltage charge at a current value of 1 C for 3 hours, and performing a constant-current discharge at 1 C was performed 100 cycles. The capacity ratio of the capacity at 20 C to the capacity at 0.2 C as well as the capacity retention ratio after 100 cycles are described in Table 1. Here, the capacity retention ratio was based on the first cycle in the process of constant current-constant voltage charging at 1 C and discharging at 1 C.

In the case of this measurement cell, a lithium metal is used as a counter electrode. Thus, each of the electrodes according to the examples and the comparative examples functions as a positive electrode since the electrode potentials of the examples and the comparative examples are nobler than the potential of the counter electrode. Accordingly, when each electrode in the examples and comparative examples is used as a negative electrode, the charge-discharge definition is opposite to the above. Here, in order to avoid any confusion, a direction where lithium ions are inserted into an electrode is referred to as "charge" and a direction where lithium ions are released therefrom is referred to as "discharge", and these terms are consistently used in this example. Note that when the active material of the embodiment is combined with a positive electrode material, it functions as the negative electrode.

The results of the examples are shown in Tables 1 and 2.

[Table 1]

[Table 1]

|  |  | Active material composition formula | Composition ratio of Nb/Ti | Additive element | Rutile type oxide phase |
| --- | --- | --- | --- | --- | --- |
|  | Example 1 | $Li_0Ti_{1.20}Nb_{2.0}O_{7.40}$ | 1.67 | Not added | Yes |
|  | Example 2 | $Li_0Ti_{1.20}Nb_{2.0}O_{7.40}$ | 1.67 | Not added | Yes |
|  | Example 3 | $Li_0Ti_{1.25}V_{0.05}Nb_{1.95}O_{7.54}$ | 1.52 | V | Yes |
|  | Example 4 | $Li_0Ti_{1.35}Fe_{05}Nb_{2.05}O_{7.9}$ | 1.52 | Fe | Yes |
|  | Example 5 | $Li_0Ti_{1.25}Mo_{0.05}Nb_{1.9}O_{7.4}$ | 1.52 | Mo | Yes |
|  | Example 6 | $Li_0Ti_{1.25}Ta_{0.05}Nb_{1.95}O_{7.54}$ | 1.52 | Ta | Yes |
|  | Example 7 | $Li_0Ti_{1.11}Nb_2O_{7.22}$ | 1.8 | Not added | Yes |
|  | Example 8 | $Li_0TiNb_2O_{6.81}$ | 2.0 | Not added | Yes |
|  | Comparative Example 1 | $Li_0TiNb_2O_7$ | 2.0 | Not added | None |
|  | Comparative Example 2 | $Li_0TiNb_2O_7.$ | 2.0 | Not added | None |
|  | Comparative Example 3 | $Li_0Ti_{0.67}Nb_{1.33}O_4$ | 2.0 | Not added | None |

[Table 2]

[Table 2]

|  | Ratio of the capacity at 20 C to the capacity at 0.2 C | Retention ratio after 100 cycles |
| --- | --- | --- |
| Example 1 | 88.5% | 78.9% |
| Example 2 | 90.9% | 82.2% |
| Example 3 | 91.2% | 79.3% |
| Example 4 | 89.6% | 81.6% |
| Example 5 | 92.4% | 80.4% |
| Example 6 | 88.7% | 78.9% |

(continued)

| | Ratio of the capacity at 20 C to the capacity at 0.2 C | Retention ratio after 100 cycles |
|---|---|---|
| Example 7 | 91.5% | 82.5% |
| Example 8 | 86.4% | 86.5% |
| Comparative Example 1 | 78.1% | 60.6% |
| Comparative Example 2 | 76.4% | 61.2% |
| Comparative Example 3 | Not operated | Not operated |

Examples 1 and 2 show the comparison of characteristics of the electrodes formed using the active material obtained by changing the mole ratio (Nb/Ti) and the rate of temperature increase was changed. Since both the examples have a structure containing the rutile type oxide, the characteristics are found to be improved as compared to Comparative Example 1. When Example 1 is compared to Example 2, in the case where the rate of temperature increase is higher, the particle diameter of rutile type $TiO_2$ particles being supported is smaller. Thus, the characteristics of Example 2 are found to be improved. The primary particle diameter of rutile type $TiO_2$ particles of Example 2 was from 10 nm to 100 nm, and the particles were uniformly supported by $TiNb_2O_7$ particles. In Examples 3 to 6 in which an additive element was further included in the same manner as Example 1, characteristics equivalent to or more than the above are found to be obtained.

In Example 7 in which the amount of Nb included in the rutile type oxide was increased as compared to that of Example 1, the electron conductivity was improved and further the characteristics are improved.

In Example 8 in which the surface of the active material was coated with $Nb_{1.33}Ti_{0.67}O_4$, the charge-discharge cycle characteristics were improved as compared to those of Example 2 (without coating). This is because the coatability of the surface of the monoclinic niobium-titanium composite oxide particles was high, and thus the surface reactivity was reduced.

According to the active material for the nonaqueous electrolyte battery of at least one of the embodiments and the examples described above, since a monoclinic niobium-titanium composite oxide particles containing a rutile type oxide is contained, it is possible attain a nonaqueous electrolyte battery which exerts a high input-output performance even in a low SOC region and is excellent in charge-discharge cycle performance.

Reference Signs List

1, 11 ... Electrode group, 2, 12 ... Container, 3, 13 ... Positive electrode, 3a, 13a ... Positive electrode current collector, 3b, 13b ... Positive electrode active material containing layer, 4, 15 ... Separator, 5, 14 ... Negative electrode, 5a, 14a ... Negative electrode current collector, 5b, 14b ... Negative electrode active material containing layer, 6, 16 ... Negative electrode terminal, 7, 17 ... Positive electrode terminal, 20 ... Battery pack, 21 ... Unit cell, 22 ... Adhesive tape, 23 ... Battery module, 24 ... Printed wiring board, 28 ... Positive electrode wiring, 29 ... Positive electrode connector, 30 ... Negative electrode wiring, 31 ... Negative electrode connector, 37 ... Housing case, 38 ... Lid.

**Claims**

1. An active material for a nonaqueous electrolyte battery comprising monoclinic niobium-titanium composite oxide particles
**characterized in that**
the monoclinic niobium-titanium composite oxide particles comprise a rutile type niobium-titanium composite oxide, wherein the active material is a composite of the rutile type niobium-titanium composite oxide and the monoclinic niobium-titanium composite oxide,
wherein the rutile type niobium-titanium composite oxide is contained in and/or covers at least a part of a surface of the monoclinic niobium-titanium composite oxide particles.

2. The active material according to claim 1, wherein the active material satisfies at least one of the following Formulae (1) and (2):

$$0.25 \le I_A/I_C \le 0.45 \quad (1)$$

$$0.7 \leq I_B/I_C \leq 1.2 \quad (2)$$

wherein the $I_A$ represents an intensity of a peak A corresponding to a Raman band of rutile type niobium-titanium composite oxide appeared at 430 cm$^{-1}$ to 450 cm$^{-1}$, the $I_B$ represents an intensity of a peak B corresponding to a Raman band of niobium-titanium composite oxide appeared at 640 cm$^{-1}$ to 660 cm$^{-1}$, and the $I_C$ represents an intensity of a peak C corresponding to a Raman band of niobium-titanium composite oxide appeared at 260 cm$^{-1}$ to 280 cm$^{-1}$ in a spectrum obtained by micro-Raman spectroscopy at a measurement wavelength of 514.5 nm.

3. The active material according to claim 1 or claim 2, comprising a composition represented by $Li_aTi_{1+A}M_bNb_{2\pm\beta}O_{7+2A\pm\sigma}$ ($0 \leq A \leq 0.6$, $0 \leq a \leq 5$, $0 \leq b \leq 0.3$, $0 \leq \beta \leq 0.3$, $0 \leq \sigma \leq 0.3$, and M represents at least one element selected from the group consisting of Fe, V, Mo, and Ta).

4. The active material according to any one of claims 1 to 3, wherein the rutile type niobium-titanium composite oxide comprises a composition ratio represented by the following formula (1):

$$0 < (N/T) \leq 2 \quad (1)$$

wherein N represents a mole number of Nb, and T represents a mole number of Ti.

5. The active material according to claim 4, wherein the rutile type niobium-titanium composite oxide is represented by $Nb_{1.33}Ti_{0.67}O_4$.

6. The active material according to any one of claims 1 to 5, wherein the monoclinic niobium-titanium composite oxide comprises a crystal structure identical or equivalent to that of $TiNb_2O_7$.

7. The active material according to any one of claims 1 to 6, further comprising a carbon-containing layer that covers a surface of the particles.

8. A nonaqueous electrolyte battery comprising:

   a positive electrode;
   a negative electrode that comprises the active material according to any one of claims 1 to 7; and
   a nonaqueous electrolyte.

9. A battery pack comprising the nonaqueous electrolyte battery according to claim 8.

10. The battery pack according to claim 9, further comprising:

    an energizing terminal; and
    a protective circuit.

11. The battery pack according to claim 9 or claim 10, which comprises nonaqueous electrolyte batteries, each of the nonaqueous electrolyte batteries is a nonaqueous electrolyte battery according to claim 8,
    wherein the nonaqueous electrolyte batteries are connected in series, in parallel or with a combination of series connection and parallel connection.

12. A vehicle comprising the battery pack according to claim 9 or 11.

13. An electrode comprising the active material according to any one of claims 1 to 7.

14. The electrode according to claim 13, further comprising a current collector and an electrode layer formed on one surface or both surfaces of the current collector and containing the active material, a binder, and a conductive agent.

**EP 2 950 372 B1**

**Patentansprüche**

1. Aktivmaterial für eine Batterie mit nichtwässrigem Elektrolyt, das monokline Niob-Titan-Kompositoxid-Partikel umfasst,

   **dadurch gekennzeichnet, dass**
   die monoklinen Niob-Titan-Kompositoxid-Partikel ein Niob-Titan-Kompositoxid vom Rutil-Typ umfassen,
   wobei das Aktivmaterial ein Komposit aus dem Niob-Titan-Kompositoxid vom Rutil-Typ und dem monoklinen Niob-Titan-Kompositoxid ist,
   wobei das Niob-Titan-Kompositoxid vom Rutil-Typ in mindestens einem Teil einer Oberfläche der monoklinen Niob-Titan-Kompositoxid-Partikel enthalten ist und/oder diese bedeckt.

2. Aktivmaterial gemäß Anspruch 1, wobei das Aktivmaterial mindestens eine der folgenden Formeln (1) und (2) erfüllt:

$$0{,}25 \leq I_A/I_C \leq 0{,}45 \quad (1)$$

$$0{,}7 \leq I_B/I_C \leq 1{,}2 \quad (2)$$

   wobei in einem Spektrum, erhalten durch Mikro-Raman-Spektroskopie bei einer Messwellenlänge von 514,5 nm, $I_A$ für eine Intensität eines Peaks A steht, der einer Raman-Bande des Niob-Titan-Kompositoxids vom Rutil-Typ entspricht, die bei 430 cm$^{-1}$ bis 450 cm$^{-1}$ erscheint, $I_B$ für eine Intensität eines Peaks B steht, der einer Raman-Bande des Niob-Titan-Kompositoxids entspricht, die bei 640 cm$^{-1}$ bis 660 cm$^{-1}$ erscheint, und $I_C$ für eine Intensität eines Peaks C steht, der einer Raman-Bande des Niob-Titan-Kompositoxids entspricht, die bei 260 cm$^{-1}$ bis 280 cm$^{-1}$ erscheint.

3. Aktivmaterial gemäß Anspruch 1 oder Anspruch 2, umfassend eine Zusammensetzung, dargestellt durch $Li_aTi_{1+A}M_bNb_{2\pm\beta}O_{7+2A\pm\sigma}$ ($0 \leq A \leq 0{,}6$, $0 \leq a \leq 5$, $0 \leq b \leq 0{,}3$, $0 \leq \beta \leq 0{,}3$, $0 \leq \sigma \leq 0{,}3$ und M steht für mindestens ein Element, ausgewählt aus der Gruppe, bestehend aus Fe, V, Mo und Ta).

4. Aktivmaterial gemäß einem der Ansprüche 1 bis 3, wobei das Niob-Titan-Kompositoxid vom Rutil-Typ ein Zusammensetzungsverhältnis umfasst, das durch die folgende Formel (1) dargestellt wird:

$$0 < (N/T) \leq 2 \quad (1)$$

   worin N für eine Molzahl des Nb steht und T für eine Molzahl des Ti steht.

5. Aktivmaterial gemäß Anspruch 4, wobei das Niob-Titan-Kompositoxid vom Rutil-Typ durch $Nb_{1{,}33}Ti_{0{,}67}O_4$ dargestellt wird.

6. Aktivmaterial gemäß einem der Ansprüche 1 bis 5, wobei das monokline Niob-Titan-Kompositoxid eine Kristallstruktur umfasst, die mit der von $TiNb_2O_7$ identisch oder äquivalent dazu ist.

7. Aktivmaterial gemäß einem der Ansprüche 1 bis 6, zusätzlich umfassend eine kohlenstoffhaltige Schicht, die eine Oberfläche der Partikel bedeckt.

8. Batterie mit nichtwässrigem Elektrolyt, umfassend:

   eine positive Elektrode;
   eine negative Elektrode, die das Aktivmaterial gemäß einem der Ansprüche 1 bis 7 umfasst; und
   einen nichtwässrigen Elektrolyt.

9. Batteriepack, umfassend die Batterie mit nichtwässrigem Elektrolyt gemäß Anspruch 8.

10. Batteriepack gemäß Anspruch 9, zusätzlich umfassend:

einen Energieanschluss; und
eine Schutzschaltung.

**11.** Batteriepack gemäß Anspruch 9 oder 10, der Batterien mit nichtwässrigem Elektrolyt umfasst, wobei jede der Batterien mit nichtwässrigem Elektrolyt eine Batterie mit nichtwässrigem Elektrolyt gemäß Anspruch 8 ist, wobei die Batterien mit nichtwässrigem Elektrolyt in Reihe, parallel oder in einer Kombination aus Reihenschaltung und Parallelschaltung geschaltet sind.

**12.** Fahrzeug, umfassend den Batteriepack gemäß Anspruch 9 oder 11.

**13.** Elektrode, umfassend das Aktivmaterial gemäß einem der Ansprüche 1 bis 7.

**14.** Elektrode gemäß Anspruch 13, zusätzlich umfassend einen Stromkollektor und eine Elektrodenschicht, die auf einer Oberfläche oder beiden Oberflächen des Stromkollektors ausgebildet ist und das Aktivmaterial, ein Bindemittel und ein leitfähiges Mittel enthält.

## Revendications

**1.** Matériau actif pour une batterie à électrolyte non aqueux comprenant des particules monocliniques d'oxyde composite de niobium et de titane
**caractérisé en ce que**
les particules monocliniques d'oxyde composite de niobium et de titane comprennent un oxyde composite de niobium et de titane de type rutile,
dans lequel le matériau actif est un composite de l'oxyde composite de niobium et de titane de type rutile et de l'oxyde composite de niobium et de titane monoclinique,
dans lequel l'oxyde composite de niobium et de titane de type rutile est contenu dans et/ou recouvre au moins une partie d'une surface des particules monocliniques d'oxyde composite de niobium et de titane.

**2.** Matériau actif selon la revendication 1, dans lequel le matériau actif satisfait au moins l'une des Formules (1) et (2) suivantes :

$$0{,}25 \leq I_A/I_C \leq 0{,}45 \ (1)$$

$$0{,}7 \leq I_B/I_C \leq 1{,}2 \ (2)$$

dans lequel le $I_A$ représente une intensité d'un pic A correspondant à une bande Raman d'oxyde composite de niobium et de titane de type rutile apparu à 430 cm$^{-1}$ à 450 cm$^{-1}$, le $I_B$ représente une intensité d'un pic B correspondant à une bande Raman d'oxyde composite de niobium et de titane apparu à 640 cm$^{-1}$ à 660 cm$^{-1}$, et le $I_C$ représente une intensité d'un pic C correspondant à une bande Raman d'oxyde composite de niobium et de titane apparu à 260 cm$^{-1}$ à 280 cm$^{-1}$ dans un spectre obtenu par micro-spectroscopie Raman à une longueur d'onde de mesure de 514,5 nm.

**3.** Matériau actif selon la revendication 1 ou la revendication 2, comprenant une composition représentée par $Li_aTi_{1+A}M_bNb_{2\pm\beta}O_{7+2A\pm\sigma}$ ($0 \leq A \leq 0{,}6$, $0 \leq a \leq 5{,}0 \leq b \leq 0{,}3$, $0 \leq \beta \leq 0{,}3$, $0 \leq \sigma \leq 0{,}3$, et M représente au moins un élément choisi dans le groupe constitué de Fe, V, Mo et Ta).

**4.** Matériau actif selon l'une quelconque des revendications 1 à 3, dans lequel l'oxyde composite de niobium et de titane de type rutile comprend un rapport compositionnel représenté par la formule (1) suivante :

$$0 < (N/T) \leq 2 \qquad (1)$$

dans lequel N représente un nombre de moles de Nb, et T représente un nombre de moles de Ti.

**5.** Matériau actif selon la revendication 4, dans lequel l'oxyde composite de niobium et de titane de type rutile est représenté par $Nb_{1,33}Ti_{0,67}O_4$.

**6.** Matériau actif selon l'une quelconque des revendications 1 à 5, dans lequel l'oxyde composite de niobium et de titane monoclinique comprend une structure cristalline identique ou équivalente à celle de $TiNb_2O_7$.

**7.** Matériau actif selon l'une quelconque des revendications 1 à 6, comprenant en outre une couche contenant du carbone qui recouvre une surface des particules.

**8.** Batterie à électrolyte non aqueux comprenant :

> une électrode positive ;
> une électrode négative qui comprend le matériau actif selon l'une quelconque des revendications 1 à 7 ; et
> un électrolyte non aqueux.

**9.** Bloc de batteries comprenant la batterie à électrolyte non aqueux selon la revendication 8.

**10.** Bloc de batteries selon la revendication 9, comprenant en outre :

> une borne d'excitation ; et
> un circuit protecteur.

**11.** Bloc de batteries selon la revendication 9 ou la revendication 10, qui comprend des batteries à électrolyte non aqueux, chacune des batteries à électrolyte non aqueux est une batterie à électrolyte non aqueux selon la revendication 8,
dans lequel les batteries à électrolyte non aqueux sont reliées en série, en parallèle ou avec une combinaison de liaison en série et de liaison en parallèle.

**12.** Véhicule comprenant le bloc de batteries selon la revendication 9 ou 11.

**13.** Électrode comprenant le matériau actif selon l'une quelconque des revendications 1 à 7.

**14.** Électrode selon la revendication 13, comprenant en outre un collecteur de courant et une couche d'électrode formée sur une surface ou les deux surfaces du collecteur de courant et contenant le matériau actif, un liant et un agent conducteur.

F I G. 1

F I G. 2

# FIG. 3

# FIG. 4

F I G. 5

F I G. 6

F I G. 7

F I G. 8

F I G. 9

F I G. 10

F I G. 11

F I G. 12

F I G. 13

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2013209863 A1
- JP 2012018778 A
- JP 2013164934 A

**Non-patent literature cited in the description**

- **ANNA LASHTABEG et al.** *Ionics,* 2003, vol. 9, 220-226